# EUROPÄISCHE PATENTSCHRIFT

(11) **EP 3 782 286 B1**
(45) Veröffentlichungstag und Bekanntmachung des Hinweises auf die Patenterteilung: **01.04.2026**
(21) Anmeldenummer: 20730417.1
(22) Anmeldetag: 03.06.2020
(51) Int. Cl.: H03K 17/96, E05B 81/78

(54) **ANORDNUNG**
ARRANGEMENT
AGENCEMENT

(30) Priorität: 11.06.2019 DE 102019115713; 10.09.2019 DE 102019124221
(43) Veröffentlichungstag der Anmeldung: 24.02.2021
(73) Patentinhaber: HUF Hülsbeck & Fürst GmbH & Co. KG, 42551 Velbert (DE)
(72) Erfinder: SIEG, Berthold, 46240 Bottrop (DE); ZIEGLER, Alexander, 42489 Wülfrath (DE)
(74) Vertreter: Bals & Vogel Patentanwälte PartGmbB
(86) Internationale Anmeldenummer: PCT/EP2020/065297
(87) Internationale Veröffentlichungsnummer: WO 2020/249436

(56) Entgegenhaltungen:
- EP-A2- 2 711 488
- WO-A1-2018/177580
- US-A1- 2017 194 960

## Beschreibung

Die vorliegende Erfindung betrifft eine Anordnung zur Bereitstellung wenigstens einer Funktion für eine Elektronik eines Fahrzeuges. Ferner bezieht sich die Erfindung auf ein Verfahren zur Bereitstellung wenigstens einer Funktion für eine Elektronik eines Fahrzeuges.

Bei Fahrzeugen werden eine Vielzahl verschiedener Elektronik-Komponenten eingesetzt, um z. B. eine Annäherung und/oder Geste in einer Umgebung des Fahrzeuges zu detektieren, oder um eine Kommunikation mit einem mobilen Gerät wie einem ID-Geber durchzuführen. Es ist aus dem Stand der Technik bekannt, dass bei Fahrzeugen mehrlagige Leiterplatten für eine solche Elektronik genutzt werden, um z. B. die Packungsdichte zu erhöhen, und/oder den für die Elektronik notwendigen Bauraum zu reduzieren. Hierbei kann z. B. eine Verarbeitungsanordnung zusammen mit wenigstens einem Sensor und/oder einer Antenne an der gleichen Leiterplatte angeordnet und auf mehreren Ebenen dieser Leiterplatte verteilt werden.

Nachteilhaft bei den bekannten Lösungen ist, dass für verschiedene Montagepositionen am Fahrzeug jeweils eine angepasste Elektronik bereitgestellt werden muss, wodurch sich der Aufwand und die Kosten für die Herstellung dieser Elektronik erhöhen kann/können. Bspw. kann es notwendig sein, die Detektion und/oder die Kommunikation links- und rechtsseitig im Bereich eines links- bzw. rechtsseitigen Türgriffes des Fahrzeuges bereitzustellen. Das hierzu erzeugte Detektions- und/oder Kommunikationsfeld kann dabei symmetrisch ausgeführt sein, z. B. jeweils vom Fahrzeug weg gerichtet sein. Damit erhöhen sich die Anforderungen und somit der Aufwand für die Herstellung.

Aus den Druckschriften US 2017/194960 A1, EP 2 711 488 A2 und WO 2018/177580 A1 sind gattungsgemäße Verfahren und Vorrichtungen bekannt.

Es ist daher eine Aufgabe der vorliegenden Erfindung, die voranstehend beschriebenen Nachteile zumindest teilweise zu beheben. Insbesondere ist es eine Aufgabe der vorliegenden Erfindung, eine verbesserte Lösung für eine derartige Elektronik vorzuschlagen.

Die voranstehende Aufgabe wird gelöst durch eine Anordnung mit den Merkmalen des unabhängigen Vorrichtungsanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen Verfahren, und jeweils umgekehrt, sodass bzgl. der Offenbarung zu den einzelnen Erfindungsaspekten stets wechselseitig Bezug genommen wird bzw. werden kann.

Die Aufgabe wird insbesondere gelöst durch eine Anordnung, vorzugsweise (elektronische) Schaltungsanordnung, zur Bereitstellung wenigstens einer Funktion für eine Elektronik eines Fahrzeuges, vorzugsweise für eine Türgriffelektronik des Fahrzeuges, bevorzugt für einen kapazitiven Sensor zur Detektion einer Aktivierungshandlung beim Fahrzeug, und/oder für eine Kommunikationsschnittstelle des Fahrzeuges, insbesondere zur Kommunikation mit einem mobilen Gerät wie einem Mobilfunkgerät oder einem elektronischen Schlüssel, welches jeweils als ein ID-Geber (Identifikationsgeber) eingesetzt werden. Die bereitgestellte Funktion kann, bspw. eine Erfassungsfunktion und/oder eine weitere Funktion, wie eine Abschirmfunktion, und/oder eine Kommunikationsfunktion ausgeführt sein.

Vorteilhaft ist es, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. Diese Kommunikation kann durch die Kommunikationsfunktion bereitgestellt sein. Der ID-Geber kann dabei durch einen dedizierten elektronischen Schlüssel oder auch durch ein anderes mobiles Gerät wie ein Smartphone bereitgestellt sein. In Abhängigkeit von der Kommunikation und/oder der Authentifizierung kann wenigstens eine Aktivierungsfunktion des Fahrzeuges aktiviert werden. Falls hierzu die Authentifizierung des ID-Gebers notwendig ist, kann es sich bei der Aktivierungsfunktion um eine sicherheitsrelevante Aktivierungsfunktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Aktivierungsfunktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst.

Auch kann die Aktivierungsfunktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion einer Aktivierungshandlung wie einer Annäherung und/oder Geste die Fahrzeugbeleuchtung aktiviert und/oder bei der Detektion der Aktivierungshandlung die Klappe betätigt. Dabei kann die Detektion einer Aktivierungshandlung wie der Annäherung des Benutzers und/oder der Geste durch die Erfassungsfunktion ermöglicht werden, insbesondere durch einen kapazitiven Sensor.

Es kann möglich sein, dass die Erfassungsfunktion bei einer Fahrzeugkomponente wie einem Türgriff, vorzugsweise der Außentürgriff des Fahrzeuges, vorgesehen ist. Mittels der Erfassungsfunktion kann bspw. die Annäherung und/oder Berührung an die Fahrzeugkomponente bzw. des Türgriffs als Aktivierungshandlung detektiert werden. Als Reaktion auf die Detektion kann eine Aktivierungsfunktion z. B. eine Entriegelung und/oder eine Öffnungsbewegung einer Klappe initiiert werden, wobei die Klappe den Türgriff aufweisen kann oder dem Türgriff zugeordnet sein kann. Die Klappe kann dabei eine Tür wie eine Seiten- und/oder Schiebetür des Fahrzeuges sein.

Des Weiteren ist es möglich, dass durch die Kommunikationsfunktion die Kommunikation bereitgestellt wird, um z. B. einen Informationsaustausch mit dem mobilen Gerät vorzunehmen. Der Informationsaustausch betrifft insbesondere den Austausch von Informationen zur Authentifizierung des mobilen Geräts beim Fahrzeug. Somit kann die erfolgreiche Authentifizierung mittels der Kommunikation eine Voraussetzung dafür sein, dass die Detektion mittels der Erfassungsfunktion die Aktivierungsfunktion auslöst.

Es ist möglich, dass mittels der Erfassungsfunktion eine Erfassung in einem Erfassungsbereich in der Umgebung des Fahrzeuges durchgeführt wird. Alternativ oder zusätzlich kann die Kommunikationsfunktion die Kommunikation in einem Kommunikationsbereich in der Umgebung des Fahrzeuges bereitstellen. Der Erfassungsbereich und/oder Kommunikationsbereich kann in Relation zur Fahrzeugkomponente bzw. zum Türgriff immer gleich angeordnet sein, unabhängig davon, ob die Fahrzeugkomponente bzw. der Türgriff links- oder rechtsseitig am Fahrzeug angeordnet wird. In anderen Worten kann die Erfassungs- und/oder Kommunikationsfunktion und/oder auch wenigstens eine weitere Funktion für unterschiedliche Montagepositionen links- und rechtsseitig am Fahrzeug gleich bereitgestellt werden. Hierbei kann der Erfassungsbereich und/oder der Kommunikationsbereich z. B. stets außen angeordnet sein, also einem Innenraum des Fahrzeuges abgewandt. Auch sind andere Konfigurationen denkbar, bei welchen der Erfassungsbereich und/oder der Kommunikationsbereich z. B. innen angeordnet ist, bspw. in einer Türgriffmulde. Somit kann durch die Anordnung des Erfassungs- und/oder Kommunikationsbereichs definiert werden, an welchem Ort die Aktivierungshandlung zur Aktivierung der Aktivierungsfunktion führt und/oder die Kommunikation stattfinden kann.

Eine erfindungsgemäße Anordnung weist ein Trägerelement auf, welches zur Montage an Montagepositionen auf unterschiedlichen Seiten und/oder Positionen des Fahrzeuges geeignet ist, um wahlweise (d. h. entsprechend einer Auswahl der Montageposition) die Montage zumindest an einer ersten oder zweiten der Montagepositionen durchzuführen. In anderen Worten kann das gleiche Trägerelement und ggf. sogar die gleiche erfindungsgemäße Anordnung sowohl an der ersten als auch an der zweiten Montageposition montiert werden (selbstverständlich nicht gleichzeitig, sondern wahlweise). Auf diese Weise kann der Aufwand für die Herstellung reduziert werden, da das Trägerelement für die verschiedenen Montagepositionen dennoch gleich ausgebildet ist. Das Trägerelement kann dabei von einer Verarbeitungsanordnung getrennt ausgeführt sein, um das Trägerelement auch dann unverändert für die verschiedenen Montagepositionen einsetzen zu können, wenn die Verarbeitungsanordnung eine Anpassung an die Montagepositionen benötigen sollte. Anders als bei herkömmlichen Anordnungen befindet sich somit nicht sämtliche Elektronik auf einem einzigen (ggf. mehrlagigen) Trägerelement, sondern es kann eine Auftrennung in einen für die Montagepositionen gleichbleibenden und einen variierenden Teil erfolgen. Doch auch wenn die Verarbeitungsanordnung nicht variiert, d. h. an die Montagepositionen angepasst werden muss, kann sich ein Vorteil durch die Auftrennung ergeben, da diese eine flexiblere Anordnung ermöglicht. Um das Trägerelement mit der Verarbeitungsanordnung elektrisch zu verbinden, können diese durch bspw. eine Zuleitung miteinander verbunden werden.

Eine erfindungsgemäße Anordnung weist ferner auf:
- ein erstes elektrisch leitendes Funktionselement an einer ersten Ebene des Trägerelements, und
- ein zweites elektrisch leitendes Funktionselement an einer zweiten Ebene des Trägerelements.

Es ist erfindungsgemäß vorgesehen, dass die Funktionselemente übereinander angeordnet und zumindest teilweise deckungsgleich ausgebildet sind (und/oder sich ggf. auch tatsächlich zumindest teilweise geometrisch überdecken), um variabel zugeordnet für eine der Ebenen eine Erfassungsfunktion und für die andere der Ebenen eine weitere Funktion, insbesondere Abschirmfunktion, bereitzustellen. In anderen Worten können die Funktionselemente jeweils geeignet sein, sowohl die Erfassungsfunktion, als auch die weitere Funktion bereitzustellen, und die Funktion davon abhängig bereitzustellen, welche Zuordnung für die Ebenen getroffen wurde.

Darüber hinaus kann eine erfindungsgemäße Anordnung nachfolgendes aufweisen:
- ein erstes Kommunikationsmittel, welches an einer bzw. der ersten Ebene des Trägerelements angeordnet ist,
- ein zweites Kommunikationsmittel, welches an einer bzw. der zweiten Ebene des Trägerelements angeordnet ist,
wobei vorzugsweise die Kommunikationsmittel gegenüberliegend angeordnet und/oder elektrisch parallel geschaltet sind, um wenigstens einen (insbesondere jeweils einen) Kommunikationsbereich zu erzeugen, welcher bzw. welche für unterschiedliche ausgewählte Montagepositionen geeignet ist bzw. sind.

Dies hat den Vorteil, dass durch die elektrische Parallelschaltung der Kommunikationsmittel die Kommunikationsfunktion verbessert werden kann, welche durch die Kommunikationsmittel bereitgestellt wird. Die Kommunikationsmittel können z. B. jeweils als Spule aufgefasst werden, deren Güte sich durch die Parallelschaltung verbessert. Konkret können Kupferverluste bzw. der Innenwiderstand der Spulen auf diese Weise reduziert werden, um die Leistungsfähigkeit und/oder die Spulengüte für die Erzeugung des Kommunikationsbereiches zu verbessern. Gleichzeitig ergibt sich durch die Anordnung der Kommunikationsmittel auf unterschiedlichen Ebenen der Vorteil, dass der Kommunikationsbereich für unterschiedliche ausgewählte Montagepositionen genutzt werden kann, ohne die Ausrichtung oder Ausbildung des Trägerelements verändern zu müssen. Die Ebenen können entsprechend jeweils einer bestimmten Montageposition zugeordnet sein, um den Kommunikationsbereich jeweils spezifisch für die Montageposition bereitzustellen. Bspw. kann bei einer linksseitig am Fahrzeug vorgesehenen Montageposition der Kommunikationsbereich sich vom Fahrzeuginnenraum abgewandt nach links erstrecken, und bei einer rechtsseitig am Fahrzeug vorgesehenen Montageposition der Kommunikationsbereich sich vom Fahrzeuginnenraum abgewandt nach rechts erstrecken. Auch bei den Kommunikationsmitteln kann es sich um elektrisch leitende Elemente handeln, welche jedoch zur Bereitstellung der Kommunikationsfunktion ausgeführt sind.

Es werden die Erfassungsfunktion und die weitere Funktion der Funktionselemente zusammengefasst als Funktionen, oder einzeln als Funktion der Funktionselemente bezeichnet. Abzugrenzen sind die Funktionen der Funktionselemente von einer Kommunikationsfunktion, welche durch Kommunikationsmittel bereitgestellt werden kann.

Es ist weiter eine Anschlussanordnung zur elektrischen Verbindung der Funktionselemente mit einer Verarbeitungsanordnung vorgesehen, um eine Verbindungsschnittstelle zur Ansteuerung der Funktionselemente für die Zuordnung der Funktionen je nach ausgewählter Montageposition bereitzustellen. Die Anschlussanordnung ermöglicht es also, eine Verbindungsschnittstelle zur elektrischen Verbindung zwischen der Verarbeitungsanordnung und den Funktionselementen bereitzustellen, um die Ansteuerung flexibel und anpassungsfähig über die elektrische Verbindung bereitzustellen. Eine Anpassung der Ansteuerung kann dann z. B. durch die Verarbeitungsanordnung und/oder durch die Anschlussanordnung selbst erfolgen. Die Nutzung der Anschlussanordnung bietet somit eine erhöhte Flexibilität für die Ansteuerung der Funktionselemente. Dies hat den weiteren Vorteil, dass durch die Nutzung der Anschlussanordnung ein Funktionstausch der Funktionen der beiden Funktionselemente ermöglicht wird. Auf diese Weise kann das Trägerelement bzw. die Anordnung sowohl für die erste Montageposition als auch für die zweite bzw. weitere Montagepositionen genutzt werden. Damit wird der Produktionsaufwand deutlich reduziert.

Die elektrisch leitenden Funktionselemente können z. B. einen elektrischen Leiter aufweisen, welcher an der entsprechenden Ebene des Trägerelements befestigt ist.

Die Ebenen (engl. layer) sind z. B. verschiedene Lagen des Trägerelements. Wenn es sich bei dem Trägerelement um eine zweilagige und insbesondere beidseitig bestückbare und/oder bedruckbare Leiterplatte handelt, können die Ebenen diesen beiden Lagen auf den beiden Seiten des Trägerelements entsprechen. Die Funktionselemente können dann beidseitig vorgesehen sein, also das erste Funktionselement auf der einen und das zweite Funktionselement auf der anderen Seite. Alternativ oder zusätzlich können auch Kommunikationsmittel in diesem Sinne beidseitig vorgesehen sein.

Insbesondere kann bei einer erfindungsgemäßen Anordnung eine Anforderung hinsichtlich der Montagepositionen definiert sein, dass die Funktionen, d. h. insbesondere die Erfassungs- und weitere Funktion (wobei die weitere Funktion vorzugsweise eine Abschirmfunktion ist), und/oder die Kommunikationsfunktion, an unterschiedlichen Seiten des Fahrzeuges gleichartig vorgesehen sein müssen. Damit einhergehend kann eine weitere Anforderung hinsichtlich der Montagepositionen definiert sein, dass die Funktionen in Bezug auf eine Fahrzeugmitte (und somit einem Fahrzeuginnenraum) mit gleicher Ausrichtung und somit symmetrisch um die Fahrzeugmitte angeordnet sein müssen. Auf diese Weise kann die gleichartige Funktion gewährleistet werden, da bspw. stets ein vom Fahrzeuginnenraum abgewandter Erfassungsbereich für die Erfassungsfunktion und/oder Kommunikationsbereich für die Kommunikationsfunktion genutzt wird.

Eine herkömmliche Lösung zur Berücksichtigung dieser Anforderung ist die Nutzung unterschiedlicher Ausbildungen des Trägerelements bzw. der Anordnung für die unterschiedlichen Montagepositionen. Bspw. kann für jede Montageposition jeweils eine spezielle Ausbildung des Trägerelements vorgesehen sein, bei welcher das Trägerelement auf mehreren Ebenen eine an die jeweilige Montageposition angepasste Elektronik und Anordnung der Funktionselemente und/oder Kommunikationsmittel aufweist. Erfindungsgemäß kann es jedoch eine vorteilhafte Lösung sein, nur eine einzige Ausbildung des Trägerelements mit den Funktionselementen und/oder Kommunikationsmitteln für beide (oder sämtliche) Montagepositionen zu verwenden. Bei dieser Lösung kann das Trägerelement als abgesetzte Leiterplatte ausgebildet sein, und somit von der weiteren Elektronik (insbesondere der Verarbeitungsanordnung), die die Ansteuerung bereitstellt, abgesetzt sein. Dies ermöglicht eine flexible und platzsparende Anordnung. Ein weiterer Vorteil ist, dass die abgesetzte Leiterplatte für die unterschiedlichen Montagepositionen geeignet ist. Bspw. sind die unterschiedlichen Montagepositionen auf unterschiedlichen Fahrzeugseiten (insbesondere links- und rechtsseitig) vorgesehen. So kann das Trägerelement vorzugsweise in links- und rechtsseitigen Türgriffen befestigt werden, welche an den Montagepositionen links- und rechtsseitig am Fahrzeug montiert werden. Die Ausrichtung des Trägerelements in Bezug auf die Fahrzeuglängsrichtung (in Fahrrichtung) und/oder Fahrzeugquerrichtung (entlang der Fahrzeugquerachse) und/oder in Richtung der Fahrzeughochachse kann jedoch für die unterschiedlichen Montagepositionen gleich sein. Konkret müssen die Trägerelemente damit auch nicht für die Montage in unterschiedlichen Türgriffen auf verschiedenen Fahrzeugseiten umgedreht werden, sodass die Kosten für die Herstellung und Montage deutlich reduziert werden können. Das Trägerelement kann somit besonders leicht nicht nur für eine sondern für beide Fahrzeugseiten ohne Veränderung der Ausrichtung in Bezug auf die Fahrzeugrichtungen eingesetzt werden. Dagegen kann die Ausrichtung in Bezug auf einen Fahrzeuginnenraum unterschiedlich sein. Darunter wird verstanden, dass bei dem linksseitig am Fahrzeug angeordneten Trägerelement eine andere Außenseite des Trägerelements zum Fahrzeuginnenraum hin ausgerichtet ist als bei dem rechtsseitig angeordneten Trägerelement.

Funktional kann es bei der Anordnung mit unterschiedlicher Ausrichtung gegenüber dem Fahrzeuginnenraum jedoch problematisch sein, die Anforderung zu erfüllen, die Funktionen mit gleicher Ausrichtung gegenüber dem Fahrzeuginnenraum bereitzustellen. Bspw. kann die Erfassungsfunktion und/oder Kommunikationsfunktion immer dem Fahrzeuginnenraum abgewandt und die weitere Funktion dem Fahrzeuginnenraum zugewandt sein, oder umgekehrt. Bei einer festen Zuordnung der weiteren Funktion zu einer bestimmten Ebene, und der Erfassungs- und/oder Kommunikationsfunktion zu einer anderen bestimmten Ebene wäre dies stets mit einem Umdrehen des Trägerelements verbunden, wenn das Trägerelement links- und rechtsseitig am Fahrzeug angeordnet werden soll. Dies kann gemäß einem weiteren Vorteil dadurch verhindert werden, dass die unterschiedlichen Funktionselemente und/oder die Kommunikationsmittel zwar auf unterschiedlichen Ebenen bzw. Seiten des Trägerelements, jedoch ansonsten an gleicher Position und deckungsgleich ausgebildet sind.

Bei den Funktionselementen kann es sich um gleich ausgebildete Leiterbahnen und/oder - flächen auf unterschiedlichen Seiten des Trägerelements handeln. Die Funktionselemente können wahlweise gemäß einer ersten Funktion (Erfassungsfunktion) oder gemäß einer zweiten Funktion (weitere Funktion) betrieben werden. Die Funktion kann vorteilhafterweise in einfacher Weise dadurch festgelegt bzw. umgestaltet werden, dass die unterschiedlichen (insbesondere links- und rechtsseitigen) Funktionselemente in unterschiedlicher Weise angesteuert werden. Hierzu kann z. B. eine unterschiedliche Anschlusskonfiguration zur Veränderung der Zuordnung der Funktionen genutzt werden, wobei die Anschlusskonfiguration z. B. mechanisch durch die Anschlussanordnung und/oder elektrisch durch die Verarbeitungsanordnung angepasst wird.

Es ist ferner denkbar, dass den Ebenen des Trägerelements in Abhängigkeit von einer Ansteuerung über die Anschlussanordnung die Erfassungsfunktion und die weitere Funktion variabel entsprechend der ausgewählten Montageposition zugeordnet wird (diese Zuordnung wird auch als Funktionszuordnung bezeichnet). Hierzu kann, sobald die ausgewählte Montageposition feststeht, die Zuordnung auf verschiedene Arten durch eine Anpassung der Ansteuerung festgelegt werden:
- die Ansteuerung wird dadurch angepasst, dass mechanisch der Anschluss der Funktionselemente über die Anschlussanordnung an die Verarbeitungsanordnung angepasst wird, wobei dies auch als mechanische Anpassung der Anschlusskonfiguration bezeichnet wird,
- die Ansteuerung wird dadurch angepasst, dass elektrisch die Funktionselemente abhängig von der Montageposition durch die Verarbeitungsanordnung angesteuert werden, wobei dies auch als elektrische Anpassung der Anschlusskonfiguration bezeichnet wird.

Zur Anpassung der Ansteuerung können die Signalwege zu den Funktionselementen angepasst werden, über welche die Signale zur Ansteuerung der Erfassungsfunktion und zur Ansteuerung der weiteren Funktion von der Verarbeitungsanordnung übertragen werden. Darunter wird auch eine Anschlusskonfiguration verstanden. Bei der mechanischen Anpassung der Anschlusskonfiguration wird die Anpassung der Signalwege z. B. dadurch erreicht, dass eine Gegenanschlussanordnung wie ein Stecker "umgedreht" also unterschiedlich mit der Anschlussanordnung verbunden wird. Bei der elektrischen Anpassung der Anschlusskonfiguration können die Signalwege z. B. durch eine Umprogrammierung der Verarbeitungsanordnung angepasst werden, und bspw. unterschiedliche Pins einer Verarbeitungseinheit angesteuert werden.

Es ist weiter denkbar, dass durch die Funktionszuordnung ausschließlich die folgenden Zuordnungen möglich sind, zwischen denen durch die Anpassung der Ansteuerung umgeschaltet werden kann:
1. Für die erste Ebene wird durch das erste Funktionselement die Erfassungsfunktion und für die zweite Ebene durch das zweite Funktionselement die weitere Funktion bereitgestellt.
2. Für die erste Ebene wird durch das erste Funktionselement die weitere Funktion und für die zweite Ebene durch das zweite Funktionselement die Erfassungsfunktion bereitgestellt.

Somit kann durch die Funktionszuordnung ein Funktionstausch ermöglicht werden. Dagegen kann bspw. ein Kommunikationsmittel immer gleich betrieben werden, bspw. können beide Kommunikationsmittel immer in gleicher Weise angesteuert werden. Es findet dann also kein Funktionstausch zwischen den Kommunikationsmitteln statt.

Nach einer weiteren Möglichkeit kann vorgesehen sein, dass die Verarbeitungsanordnung und/oder die Anschlussanordnung zur Anpassung der Ansteuerung ausgeführt ist, um die Funktionszuordnung in der Art einer Festlegung durchzuführen, welches der Funktionselemente gemäß der Erfassungsfunktion angesteuert wird, und welches der Funktionselemente gemäß der weiteren Funktion angesteuert wird. Dies ermöglicht es, dass durch die Ansteuerung der Funktionselemente die Funktionen durch die Funktionselemente auf den Ebenen gemäß der Funktionszuordnung bereitgestellt werden. Dabei können die Funktionselemente eines Trägerelements stets mit unterschiedlichen der Funktionen betrieben werden, um auch zu den Ebenen unterschiedliche der Funktionen zuzuordnen. Dies ermöglicht eine synergetische Nutzung der Erfassungsfunktion zur Erfassung und der weiteren Funktion, welche konkret eine Abschirmfunktion für die Erfassung sein kann.

Ein weiterer Vorteil im Rahmen der Erfindung ist erzielbar, wenn die erfindungsgemäße Anordnung die Verarbeitungsanordnung aufweist, wobei die Verarbeitungsanordnung dazu ausgeführt ist, über wenigstens ein erstes Anschlusselement der Anschlussanordnung das erste Funktionselement und über wenigstens ein zweites Anschlusselement der Anschlussanordnung das zweite Funktionselement anzusteuern. Hierzu erfolgt z. B. ein Anschließen der Verarbeitungsanordnung an die Anschlussanordnung, um die elektrische Verbindung und damit die Signalpfade zu den Anschlusselementen (gemäß einer mechanischen Anschlusskonfiguration) herzustellen.

Es kann weiter vorgesehen sein, dass die Verarbeitungsanordnung und/oder die Anschlussanordnung zur Anpassung der Ansteuerung für die Funktionszuordnung derart ausgeführt sind, dass die Funktionszuordnung (zumindest) eine erste Zuordnung für die erste Montageposition und eine zweite Zuordnung für die zweite Montageposition umfasst, um bei der ersten Zuordnung
- die Erfassungsfunktion über das erste Anschlusselement und die weitere Funktion über das zweite Anschlusselement anzusteuern, um insbesondere die Erfassungsfunktion in der Art einer Erfassung in einer ersten Umgebung des ersten Funktionselements und die weitere Funktion in der Art einer Abschirmung des ersten Funktionselement von einer zweiten Umgebung des zweiten Funktionselements durchzuführen,
und/oder um bei der zweiten Zuordnung
- die Erfassungsfunktion über das zweite Anschlusselement und die weitere Funktion über das erste Anschlusselement anzusteuern, um insbesondere die Erfassungsfunktion in der Art der Erfassung in der zweiten Umgebung des zweiten Funktionselements und die weitere Funktion in der Art der Abschirmung des zweiten Funktionselement von einer ersten Umgebung des ersten Funktionselements durchzuführen,
sodass vorzugsweise die Erfassung und Abschirmung je nach Montageposition auf unterschiedlichen der Ebenen und unterschiedlicher der Umgebungen durchgeführt werden. Die Anpassung der Ansteuerung für die Funktionszuordnung durch die Verarbeitungsanordnung kann z. B. dadurch erfolgen, dass elektrisch (also z. B. gemäß einer Programmierung) der Signalpfad über die Anschlusselemente angepasst wird, über welche die Erfassungsfunktion und die weitere Funktion angesteuert werden. Auch kann die Anpassung der Ansteuerung durch die Anschlussanordnung erfolgen, indem mechanisch die Zuordnung der Signalpfade zu den Anschlusselementen verändert wird (z. B. durch ein Umstecken). Die Zuordnung der Anschlusselemente zu den Funktionselementen kann hingegen unveränderlich sein, z. B. durch eine feste Verbindung über Leiterbahnen.

In einer weiteren Möglichkeit kann vorgesehen sein, dass die Anschlussanordnung zur Anpassung der Ansteuerung für die Funktionszuordnung in der Art ausgeführt ist, dass die Anschlussanordnung wenigstens ein erstes Anschlusselement aufweist, das mit dem ersten Funktionselement elektrisch verbunden ist, und wenigstens ein zweites Anschlusselement aufweist, das mit dem zweiten Funktionselement elektrisch verbunden ist, wobei die Anschlusselemente zur elektrischen Verbindung mit unterschiedlichen Gegenanschlusselementen der Verarbeitungsanordnung geeignet sind, um die Funktionszuordnung durch eine Zuordnung der Gegenanschlusselemente zu den Anschlusselementen vorzunehmen. Die Gegenanschlusselemente können insbesondere Teil einer Gegenanschlussanordnung wie eines Kabels mit einem Stecker oder Steckeraufnahme sein, um ein mechanisches Anschließen der Verarbeitungsanordnung an die Anschlussanordnung zu ermöglichen. Je nachdem wie dieses Anschließen erfolgt (z. B. der Stecker ausgerichtet wird), kann eine unterschiedliche Zuordnung der Gegenanschlusselemente zu den Anschlusselementen erfolgen. Damit werden auch die Signalpfade geändert, da bspw. über ein erstes Gegenanschlusselemente die Erfassungsfunktion und über ein zweites Gegenanschlusselement die weitere Funktion (fest) angesteuert wird. Abhängig von der Zuordnung kann dann das erste Gegenanschlusselement wahlweise mit dem ersten oder zweiten Anschlusselement elektrisch verbunden werden, um den Signalpfad für die Erfassungsfunktion zu bilden. Hingegen wird dann das zweite Gegenanschlusselement dem anderen (nicht ausgewählten) dieser Anschlusselemente elektrisch verbunden, um in entsprechender Weise den Signalpfad für die weitere Funktion zu bilden.

Erfindungsgemäß ist vorgesehen, dass die Anschlussanordnung zur Anpassung der Ansteuerung für die Funktionszuordnung in der Art ausgeführt ist, dass die Verbindungsschnittstelle auf den Ebenen jeweils unterschiedlich bereitgestellt ist, um je nach ausgewählter Montageposition eine unterschiedliche Zuordnung von Gegenanschlusselementen der Verarbeitungsanordnung zu Anschlusselementen der Anschlussanordnung vorzunehmen. Bspw. werden hierzu die Gegenanschlusselemente stets mit einer gleichen Anordnung und Ausrichtung an die Anschlusselemente (z. B. in Form einer Steckeraufnahme oder einem Stecker) angeschlossen, wobei sich die unterschiedliche Zuordnung der Gegenanschlusselemente zu den Anschlusselementen dadurch ergibt, dass die Anschlusselemente auf den unterschiedlichen Ebenen unterschiedlich angeordnet sind. Insbesondere sind hierzu die Anschlusselemente gemäß einer unterschiedlichen Reihenfolge angeordnet, was sich durch die Nutzung von Durchkontaktierungen ergeben kann. Dabei wird sich zunutze gemacht, dass bei unterschiedlichen Montagepositionen das Anschließen auf unterschiedlichen der Ebenen erfolgt (auf der Rückseite des Trägerelements ist eine unterschiedliche Reihenfolge der Anschlusselemente als auf der Vorderseite vorgesehen, wenn die Anschlusselemente jeweils als Durchkontaktierung ausgeführt sind).

Ferner kann es im Rahmen der Erfindung vorgesehen sein, dass die Anordnung die Verarbeitungsanordnung aufweist, wobei die Verarbeitungsanordnung zur Anpassung der Ansteuerung für die Funktionszuordnung in der Art ausgeführt ist, dass die Verarbeitungsanordnung wahlweise das erste Funktionselement oder das zweite Funktionselement gemäß der Erfassungsfunktion ansteuert, und das andere der Funktionselemente gemäß der weiteren Funktion ansteuert. Auf diese Weise kann die elektronische Anpassung der Anschlusskonfiguration ermöglicht werden. Für die Anpassung der Ansteuerung ist bspw. eine unterschiedliche Programmierung der Verarbeitungsanordnung oder eine unterschiedliche Signalführung bei der Verarbeitungsanordnung vorgesehen. Dann ist es lediglich erforderlich, unterschiedliche Verarbeitungsanordnungen für unterschiedliche der Montagepositionen vorzusehen, wohingegen stets das gleiche Trägerelement genutzt und je nach Montageposition nur mit unterschiedlichen Verarbeitungsanordnungen verbunden werden muss.

Es ist weiter denkbar, dass die Verarbeitungsanordnung dazu ausgebildet ist, die Ansteuerung der Funktionen entsprechend einer festen und von der Montageposition unabhängigen Zuordnung von wenigstens zwei Gegenanschlusselementen vorzunehmen, wobei die Anschlussanordnung wenigstens zwei Anschlusselemente zur wahlweisen Verbindung mit unterschiedlichen der Gegenanschlusselemente aufweist, um anhand der für die Verbindung ausgewählten Gegenanschlusselemente die Anschlusskonfiguration vorzunehmen, und damit die Erfassungs- und die weitere Funktion den Funktionselementen und damit den Ebenen zuzuordnen.

Optional kann es vorgesehen sein, dass die Anschlussanordnung wenigstens zwei Anschlusselemente aufweist. Die zwei Anschlusselemente können jeweils zur Bereitstellung der Verbindungsschnittstelle auf beiden der Ebenen beidseitig zur Verbindung mit einem Gegenanschlusselement der Verarbeitungsanordnung ausgebildet sein, vorzugsweise zum lösbaren Verbinden (d. h. Anschließen) der Funktionselemente an unterschiedlichen Außenseiten des Trägerelements, wobei bevorzugt die Anschlusselemente hierzu wenigstens eine Durchkontaktierung aufweisen. Damit ist auch die Anschlussanordnung für unterschiedliche Montagepositionen geeignet. Wenn die Montagepositionen z. B. eine rechts- und linksseitige Montage am Fahrzeug umfassen, bei welcher die Ausrichtung des Trägerelements in Bezug auf die Fahrzeugrichtungen (Hoch-, Längs- und Querrichtung) gleich ist, kann auf diese Weise das Anschließen immer von der gleichen dem Fahrzeuginnenraum zu- oder abgewandten Seite erfolgen. Hierzu kann die Durchkontaktierung genutzt werden, um ein Anschlusselement von beiden Außenseiten des Trägerelements zugänglich zu machen.

Auch ist es optional denkbar, dass die Anschlussanordnung beidseitig am Trägerelement die Verbindungsschnittstelle aufweist, um entsprechend der unterschiedlichen Montagepositionen wenigstens ein Gegenanschlusselement wahlweise an einer der beiden Außenseiten des Trägerelements an die Verbindungsschnittstelle anzuschließen, und insbesondere um die Funktionszuordnung in Abhängigkeit von der ausgewählten Außenseite vorzunehmen, an welcher der Anschluss erfolgt. Insbesondere durch die Nutzung von Durchkontaktierungen (engl. "vias") am Trägerelement kann die Kontaktierung eines Anschlusselementes zum Anschließen von beiden Seiten des Trägerelements aus erfolgen. Je nachdem, von welcher Seite jedoch diese Kontaktierung erfolgt, kann die Anordnung der Anschlusselemente eine unterschiedliche Reihenfolge aufweisen. Diese unterschiedliche Reihenfolge kann ggf. genutzt werden, um die Funktionszuordnung vorzunehmen. (wenn bspw. die Gegenanschlusselemente stets in der gleichen Anordnung und damit Reihenfolge vorliegen). Alternativ oder zusätzlich kann die Anordnung der Anschlusselemente auch symmetrisch erfolgen, und einige der Anschlusselemente mehrfach (und funktionsgleich) vorgesehen sein, um beim Anschließen die unterschiedliche Reihenfolge zu kompensieren.

Ein weiterer Vorteil kann im Rahmen der Erfindung erzielt werden, wenn die Anschlussanordnung wenigstens ein erstes Anschlusselement aufweist, welches mit dem ersten Funktionselement elektrisch verbunden ist, um darüber variabel die Ansteuerung der Erfassungs- oder der weiteren Funktion beim ersten Funktionselement bereitzustellen, und/oder wenigstens ein zweites Anschlusselement aufweist, welches mit dem zweiten Funktionselement elektrisch verbunden ist, um darüber variabel die Ansteuerung der Erfassungs- oder der weiteren Funktion beim zweiten Funktionselement bereitzustellen, und/oder ein drittes und viertes Anschlusselement aufweist, welche mit einem ersten und vorzugsweise (z. B. über Durchkontaktierungen) mit einem zweiten Kommunikationsmittel am Trägerelement elektrisch verbunden sind, um darüber eine Ansteuerung einer Kommunikationsfunktion, vorzugsweise einer Nahfeldkommunikation, bevorzugt NFC, bereitzustellen. Damit kann die Anschlussanordnung z. B. als eine elektrische Verbindungsschnittstelle wie ein Stecker oder eine Buchse zur Ansteuerung der verschiedenen Funktionen genutzt werden. Um neben einer hierzu notwendigen elektrischen Kontaktierung noch eine zusätzliche Stabilität der Kontaktierung zu bieten, kann die Anschlussanordnung ggf. mechanische Befestigungsmittel, wie z. B. Rastmittel oder dergleichen, aufweisen. Die Anschlusselemente selbst sind bspw. als elektrisch leitende Kontakte und/oder Pins oder dergleichen ausgeführt.

Es ist weiter denkbar, dass ein drittes und viertes Anschlusselement außenliegend in Bezug auf ein erstes und zweites Anschlusselement der Anschlussanordnung an dem Trägerelement angeordnet ist. Auf diese Weise können unabhängig von der Außenseite des Trägerelements, von welcher das Anschließen an die Anschlussanordnung erfolgt, stets die außenliegenden Anschlusselemente dem dritten und vierten Anschlusselement und damit z. B. der Kommunikationsfunktion zugeordnet werden. Es kann also für beide Außenseiten zum Anschließen die gleiche Gegenanschlussanordnung der Gegenanschlusselemente genutzt werden. Die innenliegenden Anschlusselemente können ebenfalls symmetrisch angeordnet sein (z. B. dadurch, dass zwei zweite Anschlusselemente außenliegend zum ersten Anschlusselement angeordnet sind). Damit wird auch die Kontaktierung der ersten und zweiten Anschlusselemente unabhängig von der Außenseite zum Anschließen. Alternativ oder zusätzlich kann die unterschiedliche Reihenfolge des ersten und zweiten Anschlusselementes auch genutzt werden, um darüber die Ansteuerung zur Funktionszuordnung anzupassen.

Vorteilhafterweise kann bei der Erfindung vorgesehen sein, dass die Funktionselemente sich im Wesentlichen und/oder zumindest überwiegend geometrisch überdecken, insbesondere um die weitere Funktion als zumindest einseitige Abschirmung der Erfassungsfunktion bereitzustellen. Die geometrisch gleiche Anordnung hat dabei den Vorteil, dass ein Funktionstausch möglich ist. In anderen Worten können sowohl das erste als auch das zweite Funktionselement beide Funktionen (Erfassungs- und weitere Funktion) bereitstellen.

Es ist ferner denkbar, dass die Funktionselemente positionsgleich und insbesondere deckungsgleich auf den jeweiligen Ebenen angeordnet sind, vorzugsweise sodass die Erfassungsfunktion unabhängig von der Auswahl der Montageposition in gleicher Weise jedoch für unterschiedliche Umgebungen bereitgestellt ist, insbesondere gleich hinsichtlich der Position und Erstreckung eines durch die Funktionselemente erzeugten elektrischen Feldes. In anderen Worten können die beiden Ebenen und damit ggf. auch die beiden Seiten des Trägerelements ein zumindest teilweise oder im Wesentlichen gleiches Layout aufweisen, um die Erfassungsfunktion auf den beiden Ebenen bzw. Seiten bereitstellen zu können. Das elektrische Feld kann damit durch die Funktionselemente gleich erzeugt werden, und auch in gleicher Weise durch das gegenüberliegende Funktionselement abgeschirmt werden, wenn das gegenüberliegende Funktionselement gemäß der Abschirmfunktion angesteuert wird. In anderen Worten können die Funktionselemente abhängig von der Montageposition alternierend mit den Funktionen angesteuert werden. Das Feld erstreckt sich dann bei beiden Montagepositionen z. B. immer in einer Umgebung, welche ausgehend vom Trägerelement weg vom Fahrzeuginnenraum führt.

Außerdem kann es im Rahmen der Erfindung von Vorteil sein, dass das Trägerelement zur Montage an den Montagepositionen auf gegenüberliegenden Seiten des Fahrzeuges ausgeführt ist, und vorzugsweise eine an die Montagepositionen derart angepasste Montageanpassung aufweist, dass die Montage an den Montagepositionen mit gleicher Ausrichtung in Fahrzeuglängsrichtung durchführbar und insbesondere mit unterschiedlicher Ausrichtung in Fahrzeuglängsrichtung verhindert ist, bevorzugt sodass bei der Montage an der ersten Montageposition die erste Ebene einem Innenraum des Fahrzeuges abgewandt und die zweite Ebene dem Innenraum zugewandt ist, und bei der Montage an der zweiten Montageposition die zweite Ebene dem Innenraum abgewandt und die erste Ebene dem Innenraum zugewandt ist, um insbesondere die Erfassungs- und weitere Funktion symmetrisch am Fahrzeug bereitzustellen. Auf diese Weise kann das Trägerelement für beide Montagepositionen verwendet werden, wobei dann lediglich andere Ebenen bzw. Seitenflächen des Trägerelements zum Innenraum ausgerichtet sind. In anderen Worten sind für unterschiedliche Montagepositionen die Ebenen unterschiedlich in Bezug auf den Innenraum ausgerichtet (in Bezug auf die Fahrzeugrichtungen links, rechts und vorne, hinten kann das Trägerelement für beide Montagepositionen jedoch gleich ausgerichtet sein). Dennoch soll ggf. die Erfassungs- und weitere Funktion in gleicher Weise in Bezug auf den Innenraum ausgerichtet sein, also z. B. immer die weitere Funktion dem Innenraum zugewandt und die Erfassungsfunktion dem Innenraum abgewandt sein (um z. B. die Detektion der Aktivierungshandlung von außen zu ermöglichen). Alternativ kann die Erfassungsfunktion dem Innenraum zugewandt und die weitere Funktion dem Innenraum abgewandt sein, um z. B. die Detektion der Aktivierungshandlung in einer Türgriffmulde zu ermöglichen. Die Ausrichtung der Erfassungs- und weiteren Funktion kann also symmetrisch am Fahrzeug erfolgen, da die Erfassungsfunktion gemeinsam mit der weiteren Funktion den Ort definiert, an welchem die Aktivierungshandlung detektiert werden kann. Die symmetrische Bereitstellung umfasst insbesondere eine Anordnung des durch die Erfassungsfunktion erzeugten elektrischen Feldes symmetrisch um eine Symmetrieachse in Fahrzeuglängsrichtung, und ggf. in entsprechender Weise die symmetrische Abschirmung durch die Abschirmfunktion.

Es kann weiter vorgesehen sein, dass das Trägerelement dadurch zur wahlweisen Montage an einer der wenigstens zwei unterschiedlichen Montagepositionen des Fahrzeuges ausgeführt ist, dass das Trägerelement sowohl an der einen als auch an der anderen Montageposition befestigt werden kann, und eine entsprechend hierzu angepasste geometrische Ausbildung aufweist. Alternativ oder zusätzlich können sich die Montagepositionen dadurch unterscheiden, dass unterschiedliche der zwei Ebenen, insbesondere deren Seitenflächen des Trägerelements einem Innenraum des Fahrzeuges zugewandt sind.

Vorteilhaft ist es darüber hinaus, wenn im Rahmen der Erfindung das Trägerelement als eine mindestens oder genau zweiseitige Leiterplatte ausgebildet ist, um eine beidseitige Aufnahme der Funktionselemente bereitzustellen, bei welcher das erste Funktionselement an einer ersten Außenseite des Trägerelements und das zweite Funktionselement an einer gegenüberliegenden zweiten Außenseite des Trägerelements befestigt ist, um die Erfassungs- und weitere Funktion auf unterschiedlichen Außenseiten bereitzustellen und/oder die Funktionselemente und ggf. auch die Anschlussanordnung von beiden Außenseiten zugänglich zu machen. Die mindestens oder genau zweiseitige Leiterplatte kann somit mindestens oder genau zwei Ebenen aufweisen, welche beidseitig zur Aufnahme der Funktionselemente ausgeführt sind.

Ferner kann im Rahmen der Erfindung vorgesehen sein, dass die Funktionselemente jeweils sowohl als eine kapazitive Sensorelektrode zur Bereitstellung der Erfassungsfunktion als auch als eine Abschirmungselektrode zur Bereitstellung der weiteren Funktion ausgebildet sind, um die Funktionen je nach Funktionszuordnung und ausgewählter Montageposition bereitzustellen, wobei vorzugsweise die Funktionselemente hierzu jeweils geometrisch gleich mit einer flächigen Form ausgebildet sind. Die gleiche Ausbildung ermöglicht es dabei, sowohl als Abschirmungselektrode als auch als Sensorelektrode ausgebildet zu sein. Bevorzugt können dabei die Funktionselemente jeweils beabstandete Flächenelemente aufweisen, insbesondere Rippen, welche zur Verringerung von Wirbelstromverlusten bei einer benachbarten, und die Funktionselemente umgebenden, Kommunikationsschnittstelle dienen.

Eine Ansteuerung der Erfassungsfunktion und damit des Funktionselements, welches zur Bereitstellung der Erfassungsfunktion genutzt wird, kann bspw. durch ein wiederholtes Auf- und Entladen dieses Funktionselements erfolgen. Auf diese Weise kann durch eine Auswertung dieser Auf- und Entladung durch die Verarbeitungsanordnung (z. B. durch eine Ladungskumulation der dabei übertragenen Ladungsträger) bspw. eine veränderliche Kapazität ermittelt werden, welche durch das Funktionselement gegenüber der Umgebung des Funktionselements bereitgestellt wird. Diese veränderliche Kapazität kann wiederum abhängig sein von der Umgebung, sodass auf diese Weise die Aktivierungshandlung in der Umgebung detektiert werden kann.

Es ist zudem möglich, dass zur Ansteuerung der Abschirmfunktion das hierzu angesteuerte Funktionselement auf ein festes elektrisches Potential gelegt wird (z. B. ein Massepotential). Auch kann es möglich sein, dass das hierzu angesteuerte Funktionselement stets mit dem gleichen Potential angesteuert wird, wie das zur Erfassungsfunktion genutzte Funktionselement. In anderen Worten folgt das elektrische Potential am, zur Bereitstellung der Abschirmfunktion genutzten, Funktionselement dem elektrischen Potential am, zur Bereitstellung der Erfassungsfunktion genutzten, Funktionselement. Somit können beide Funktionselemente zur kapazitiven Erfassung angesteuert werden, und dieser auf unterschiedliche Weise (Erzeugung des elektrischen Feldes durch die Erfassungsfunktion und Abschirmung durch die Abschirmfunktion) dienen.

Bspw. kann es vorgesehen sein, dass die Verarbeitungsanordnung dazu ausgeführt ist, über die Anschlussanordnung die Funktionselemente zur kapazitiven Erfassung und eine die Funktionselemente umgebende Kommunikationsschnittstelle zur Nahfeldkommunikation (insbesondere zur NFC, also Near Field Communication) alternierend (und insbesondere niemals gleichzeitig) anzusteuern. Damit kann eine kompakte Anordnung bereitgestellt werden, um die Funktionen platzsparend bereitzustellen.

Gemäß einem weiteren Vorteil kann vorgesehen sein, dass das Trägerelement als eine Leiterplatte mit den wenigstens oder genau zwei Ebenen, insbesondere als eine Mehrlagenplatine, ausgebildet ist, wobei eine Anschlussanordnung auf beiden Ebenen, insbesondere mittels wenigstens einer Durchkontaktierung, angeordnet ist. Dies ermöglicht es, dass die Anschlussanordnung von beiden Seiten zugänglich ist.

Es kann vorgesehen sein, dass die erste und zweite Ebene unmittelbar benachbarte und/oder miteinander verbundene und/oder miteinander kontaktierende und/oder die einzigen Ebenen, insbesondere Lagen, des Trägerelements sind. Auf diese Weise kann auch der Vorteil erzielt werden, dass die Funktionselemente bzw. die Kommunikationsmittel gegenüberliegend und/oder unmittelbar benachbart angeordnet sind. Damit kann eine elektrische bzw. magnetische Wechselwirkung zwischen den Funktionselementen bzw. Kommunikationsmitteln erzeugt werden.

Bei einer weiteren Möglichkeit kann es vorgesehen sein, dass die Kommunikationsmittel jeweils zur Erzeugung eines Kommunikationsfelds, vorzugsweise magnetischen Felds, ausgeführt sind, um jeweils einen (des wenigstens einen) Kommunikationsbereich(s) zu erzeugen. In anderen Worten können auch mehrere Kommunikationsbereiche vorgesehen sein, welche jeweils durch eines der Kommunikationsmittel bzw. das Kommunikationsfeld erzeugt wird. Ferner können die Kommunikationsmittel geometrisch parallel angeordnet sein, sodass sich die Kommunikationsfelder und insbesondere somit auch die Kommunikationsbereiche an beiden der Ebenen, insbesondere im Wesentlichen symmetrisch und/oder im Wesentlichen räumlich gleich, erstrecken. Damit kann die Eignung des wenigstens einen Kommunikationsbereiches für unterschiedliche ausgewählte Montagepositionen dadurch erzielt werden, dass an jeder der Ebenen ein Kommunikationsbereich erzeugt wird, und die Kommunikationsbereiche sich zudem symmetrisch erstrecken können. Bei der Montage an der ersten Montageposition kann z. B. (insbesondere nur) einer der Kommunikationsbereiche und bei der Montage an der zweiten Montageposition stattdessen der andere der Kommunikationsbereiche genutzt werden.

Eine parallele Anordnung der Kommunikationsmittel, insbesondere in der Art einer Parallelführung der Kommunikationsmittel, hat den Vorteil, dass die Kommunikationsfelder durch die Kommunikationsmittel magnetisch und geometrisch symmetrisch erzeugt werden können. Ein gleicher Stromfluss durch die Kommunikationsmittel kann dabei eine im Wesentlichen gleiche Feldstärkenverteilung der Kommunikationsfelder bewirken. Ferner ist auch eine Zwangssymmetrierung durch die symmetrischen gekoppelten Kommunikationsfelder möglich (in dem Zusammenhang kann von einer magnetischen Symmetrierung der Kommunikationsfelder gesprochen werden).

Es kann zudem vorteilhaft sein, wenn die Kommunikationsmittel eine gleiche Länge aufweisen. Darunter wird die Länge des Strompfads verstanden, welcher durch die jeweiligen Kommunikationsmittel bereitgestellt wird.

Vorteilhafterweise kann im Rahmen der Erfindung vorgesehen sein, dass die Kommunikationsmittel derart auf den jeweiligen Ebenen angeordnet sind, dass die von den Kommunikationsmitteln erzeugten magnetischen Felder (Kommunikationsfelder), insbesondere magnetisch, symmetrisch sind, und insbesondere hinsichtlich der Feldstärke (und insbesondere der Feldstärkeverteilung) im Wesentlichen gleich ausgeführt sind, um bevorzugt beidseits des Trägerelements den Kommunikationsbereich (gleichartig) zur Nahfeldkommunikation zu erzeugen. Unter gleichartig wird dabei insbesondere verstanden, dass die nutzbare Kommunikationsreichweite im Wesentlichen gleich ist. Dies kann bspw. durch eine geometrisch parallele Anordnung und elektrische Parallelschaltung der Kommunikationsmittel erzielt werden.

Ein weiterer Vorteil kann im Rahmen der Erfindung erzielt werden, wenn die Kommunikationsmittel sich zumindest teilweise geometrisch überdecken und/oder geometrisch parallel verlaufen und/oder deckungsgleich ausgebildet sind, um beidseits des Trägerelements jeweils den (d. h. einen des wenigstens einen) Kommunikationsbereich(s) zu erzeugen, sodass vorzugsweise je nach ausgewählter Montageposition ein anderer der Kommunikationsbereiche einem Innenraum des Fahrzeuges abgewandt ist. Damit kann der Kommunikationsbereich zur Kommunikation zugänglich sein, welcher an der dem Innenraum abgewandten Ebene erzeugt wird. Der Kommunikationsbereich ist insbesondere dann dem Innenraum abgewandt, wenn dieser durch das dem Innenraum abgewandte Kommunikationsmittel erzeugt wird.

Bspw. kann es vorgesehen sein, dass die Kommunikationsmittel mit einem derart geringen Abstand voneinander angeordnet sind, dass durch die von den Kommunikationsmitteln erzeugen magnetischen Felder (Kommunikationsfelder) eine gegenseitige magnetische Kopplung, insbesondere zur Symmetrierung der Felder, erfolgt. In diesem Fall kann auch von einer Zwangssymmetrierung durch die symmetrisch gekoppelten Felder gesprochen werden. Der Abstand beträgt dabei z. B. maximal 1 cm oder maximal 2 cm oder maximal 5 cm. Insbesondere können die Ebenen hierzu direkt benachbart sein und damit insbesondere kontaktieren.

Des Weiteren kann es vorgesehen sein, dass die Kommunikationsmittel derart ausgebildet und/oder zueinander angeordnet sind, dass hierdurch eine (gegenseitige) magnetische Kopplung durch die Kommunikationsmittel bereitgestellt wird. Die Kommunikationsmittel können jeweils zur Erzeugung eines Kommunikationsfelds, vorzugsweise magnetischen Felds, ausgeführt sein, um jeweils einen Kommunikationsbereich zu erzeugen, wobei die Kommunikationsmittel geometrisch parallel angeordnet sein können, sodass sich vorzugsweise die Kommunikationsfelder und insbesondere die Kommunikationsbereiche an beiden der Ebenen - und insbesondere symmetrisch - erstrecken. Die magnetische Kopplung kann für diese Kommunikationsfelder bereitgestellt werden. Hierbei kann der Koppelfaktor z. B. zwischen 0,6 und 0,99, vorzugsweise zwischen 0,9 und 0,95 liegen. In anderen Worten kann auf diese Weise die Gesamtinduktivität ungefähr der Einzelinduktivität der Kommunikationsmittel entsprechen. Obwohl die Kommunikationsmittel (schaltungstechnisch) miteinander parallel verschaltet sein können, kann auch dann auf diese Weise die Feldstärke des einzelnen Kommunikationsfeldes nahezu dem eines einzelnen nicht parallel verschalteten Kommunikationsmittels (insbesondere Spule) entsprechen. Dadurch kann der durch die Parallelschaltung der Kommunikationsmittel hervorgerufene Verlust der Feldstärke reduziert werden, z. B. maximal halb so hoch sein. Die Kommunikationsmittel, d. h. insbesondere die Leiterbahnen der Kommunikationsmittel, können dabei räumlich so nahe beieinander liegen (also z. B. räumlich und/oder geometrisch parallel), dass der vorgenannte Effekt (magnetische Kopplung) bzw. der hohe Koppelfaktor erzielt wird. Dadurch wird auch eine sehr gute Feldsymmetrierung erzielt.

Des Weiteren kann vorgesehen sein, dass die Kommunikationsmittel jeweils eine Antenne zur Nahfeldkommunikation, vorzugsweise NFC-Antenne, ausbilden. Dies ermöglicht eine Kommunikation im Kommunikationsbereich z. B. zur Authentifizierung eines mobilen Geräts wie eines ID-Gebers am Fahrzeug. Auch kann ggf. eine induktive Stromerzeugung durch die Nahfeldkommunikation im Kommunikationsbereich möglich sein, um das mobile Gerät zur Authentifizierung mit Energie zu versorgen.

Auch ist es optional denkbar, dass die Kommunikationsmittel jeweils in der Form einer Leiterbahn in Schleifenform und/oder einer Schleifenantenne und/oder einer Spule zur Nahfeldkommunikation ausgebildet sind. Dies ermöglicht eine besonders zuverlässige Kommunikation.

Außerdem ist es von Vorteil, wenn das Trägerelement zur Montage an den Montagepositionen auf gegenüberliegenden Seiten des Fahrzeuges, jedoch mit gleicher Ausrichtung entlang einer Fahrzeuglängsrichtung und/oder Fahrzeugquerrichtung und/oder Fahrzeughochrichtung, ausgeführt ist, wobei vorzugsweise die Kommunikationsmittel beidseitig an dem Trägerelement angeordnet sind, um auf den gegenüberliegenden Seiten des Fahrzeuges den Kommunikationsbereich funktionsgleich bereitzustellen. Unter funktionsgleich wird dabei insbesondere verstanden, dass die Kommunikationsfunktion mit gleicher Kommunikationsreichweite und/oder geometrischer Erstreckung des Kommunikationsbereichs in Bezug auf den Fahrzeuginnenraum (also symmetrisch um den Fahrzeuginnenraum und/oder in einer Richtung weg weisend vom Fahrzeuginnenraum) bereitgestellt werden kann. Der Kommunikationsbereich kann dabei vorzugsweise als ein Nahfeld am Türgriff im Außenbereich des Fahrzeuges definiert sein.

Ferner kann es im Rahmen der Erfindung vorgesehen sein, dass wenigstens eine Durchkontaktierung einer Anschlussanordnung am Trägerelement vorgesehen ist, um die Kommunikationsmittel (schaltungstechnisch) miteinander parallel zu verschalten, und vorzugsweise wenigstens eine weitere Durchkontaktierung der Kommunikationsmittel vorgesehen ist, um die Kommunikationsmittel zusätzlich elektrisch miteinander zu verbinden. Die weitere Verbindung ermöglicht eine zusätzliche Verringerung der Verlustleistung. Dabei kann die zusätzliche Verbindung z. B. ungefähr auf gleicher Länge der Kommunikationsmittel erfolgen, und/oder jeweils beanstandet zur Durchkontaktierung für die Parallelschaltung.

Optional kann es vorgesehen sein, dass eine Anschlussanordnung am Trägerelement vorgesehen ist, um eine Verbindungsschnittstelle mit den Kommunikationsmitteln bereitzustellen, wobei die Anschlussanordnung zur beidseitigen Verbindung mit einer Verarbeitungsanordnung ausgeführt ist. Hierzu weist die Anschlussanordnung insbesondere Durchkontaktierungen auf, um den beidseitigen Anschluss zu ermöglichen.

Bevorzugt kann im Rahmen der Erfindung vorgesehen sein, dass eine Anschlussanordnung am Trägerelement vorgesehen ist, wobei die Anschlussanordnung wenigstens zwei außenliegende Anschlusselemente aufweist, um eine Verbindungsschnittstelle mit den Kommunikationsmitteln bereitzustellen, und vorzugsweise wenigstens zwei weitere innenliegende und funktionsgleiche Anschlusselemente aufweist, welche über ein Verbindungselement unmittelbar miteinander elektrisch verbunden, insbesondere kurzgeschlossen, sind, um eine Kompensationsfunktion für die außenliegenden Anschlusselemente bereitzustellen. Die funktionsgleichen Anschlusselemente können z. B. solche Anschlusselemente sein, welche zum gleichen elektrischen Potential, insbesondere Funktionselement, führen. Somit kann es sich dabei um redundante Anschlusselemente handeln. Allerdings kann die Verbindung durch das Verbindungselement es ermöglichen, dass bei Anschluss einer Gegenanschlussanordnung die Kompensationsfunktion aktiviert wird. Hierzu wird bspw. durch die Gegenanschlussanordnung ein Stromkreis geschlossen, welcher durch die funktionsgleichen Anschlusselemente und das Verbindungselement gebildet ist.

Außerdem kann es im Rahmen der Erfindung von Vorteil sein, dass eine Anschlussanordnung am Trägerelement und eine Gegenanschlussanordnung, insbesondere in der Form eines Flachbandkabels, zum Anschluss an die Anschlussanordnung vorgesehen ist, wobei bevorzugt die Gegenanschlussanordnung nachfolgendes aufweist:
- ein erstes Gegenanschlusselement, um einen Strompfad für eine Ansteuerung wenigstens einer Funktion der Anordnung bereitzustellen, insbesondere durch eine elektrische Verbindung mit einem der Funktionselemente,
- wenigstens zwei zweite und insbesondere funktionsgleiche Gegenanschlusselemente, um (insbesondere gemeinsam) einen Strompfad für eine Ansteuerung wenigstens einer weiteren Funktion der Anordnung bereitzustellen, insbesondere durch eine elektrische Verbindung mit dem anderen der Funktionselemente,
- wenigstens ein drittes und viertes Gegenanschlusselement, um für eine Ansteuerung der Kommunikationsfunktion einen Stromkreis mit den Kommunikationsmitteln auszubilden.

Es kann möglich sein, dass die Gegenanschlusselemente zumindest teilweise räumlich parallel und nebeneinander angeordnet sind bzw. sich erstrecken. Die Gegenanschlusselemente können z. B. als langgestreckte elektrische Leiter ausgeführt sein. Das erste Gegenanschlusselement kann zwischen den zweiten Gegenanschlusselementen angeordnet sein, und die zweiten Gegenanschlusselemente können zwischen den dritten und vierten Gegenanschlusselementen angeordnet sein. Ferner können die zweiten Gegenanschlusselemente über wenigstens ein Verbindungselement (insbesondere im an die Anschlussanordnung angeschlossenen Zustand über zwei Verbindungselemente) miteinander elektrisch verbunden sein, um einen Kompensationsstromkreis zur Reduzierung oder Verhinderung des Kommunikationsbereichs im Bereich der Gegenanschlussanordnung bereitzustellen, wobei sich vorzugsweise dieser Bereich zwischen einem ersten der Verbindungselemente der Anschlussanordnung und einem zweiten der Verbindungselemente der Gegenanschlussanordnung erstreckt. Hierbei kann der Vorteil erzielt werden, dass der Kommunikationsbereich nur an der Ebene und nicht an der Gegenanschlussanordnung erzeugt wird. Dabei wird sich zunutze gemacht, dass der Kompensationsstromkreis in Wechselwirkung mit den dritten und vierten Gegenanschlusselementen steht. Die dritten und vierten Gegenanschlusselemente erzeugen dabei wie die Kommunikationsmittel ein magnetisches Feld, welches grundsätzlich zur Kommunikation dienen kann. Jedoch wird dieses Feld durch die benachbarte Anordnung des Kompensationsstromkreises neutralisiert.

Es kann optional möglich sein, dass eine Anschlussanordnung vorgesehen ist, um eine Verbindungsschnittstelle mit den Kommunikationsmitteln bereitzustellen, wobei die Anschlussanordnung zur beidseitigen Verbindung mit einer Verarbeitungsanordnung ausgeführt ist. Die Verarbeitungsanordnung kann dabei ggf. die Kommunikation steuern und insbesondere durch eine Ladungsübertragung über ein drittes und viertes Gegenanschlusselement das Kommunikationsfeld erzeugen.

Ferner ist es optional vorgesehen, dass das Trägerelement als eine Leiterplatte mit den wenigstens oder genau zwei Ebenen, insbesondere als eine Mehrlagenplatine, ausgebildet ist, wobei eine Anschlussanordnung auf beiden Ebenen, insbesondere verbunden durch wenigstens eine Durchkontaktierung, angeordnet ist. Auf diese Weise ergibt sich eine vielseitig einsetzbare und kompakte Bauweise.

Ebenfalls Gegenstand der Erfindung ist ein Verfahren zur Bereitstellung wenigstens einer Kommunikationsfunktion für eine Elektronik eines Fahrzeuges. Hierbei ist vorgesehen, dass ein erstes und ein zweites Kommunikationsmittel an unterschiedlichen Ebenen eines Trägerelements vorgesehen sind, wobei die Kommunikationsmittel gegenüberliegend angeordnet und elektrisch parallel geschaltet sind, um wenigstens einen Kommunikationsbereich zu erzeugen, welcher für unterschiedliche ausgewählte Montagepositionen am Fahrzeug geeignet ist. Dabei können die nachfolgenden Schritte durchgeführt werden, vorzugsweise nacheinander oder in beliebiger Reihenfolge, wobei einzelne Schritte auch wiederholt durchgeführt werden können:
- Durchführen einer Montage des Trägerelements wahlweise zumindest an einer ersten oder zweiten der Montagepositionen, wobei die Montagepositionen für unterschiedliche Seiten des Fahrzeuges spezifisch sind,
- Anschließen einer Verarbeitungsanordnung an eine Anschlussanordnung am Trägerelement, um die Kommunikationsmittel mit der Verarbeitungsanordnung elektrisch zu verbinden, wobei die Anschlussanordnung eine Verbindungsschnittstelle zur Ansteuerung der Kommunikationsfunktion bereitstellt.

Damit bringt das erfindungsgemäße Verfahren die gleichen Vorteile mit sich, wie sie ausführlich mit Bezug auf eine erfindungsgemäße Anordnung beschrieben worden sind. Zudem kann das Verfahren geeignet sein, eine erfindungsgemäße Anordnung zu montieren. Des Weiteren ist es denkbar, dass das Trägerelement mit den Kommunikationsmitteln und der Anschlussanordnung und insbesondere die Verarbeitungsanordnung entsprechend einer erfindungsgemäßen Anordnung ausgebildet sind.

Ebenfalls Gegenstand der Erfindung ist ein Verfahren zur Bereitstellung wenigstens einer Funktion für eine Elektronik eines Fahrzeuges.

Hierbei ist insbesondere vorgesehen, dass ein erstes und ein zweites elektrisch leitendes Funktionselement an unterschiedlichen Ebenen eines Trägerelements vorgesehen ist, um variabel zugeordnet für eine der Ebenen eine Erfassungsfunktion und für die andere der Ebenen eine weitere Funktion, insbesondere Abschirmfunktion, bereitzustellen.

Bei dem erfindungsgemäßen Verfahren können dabei die nachfolgenden Schritte durchgeführt werden, wobei die Schritte insbesondere in der angegebenen Reihenfolge oder in beliebiger Reihenfolge, und ggf. auch wiederholt durchgeführt werden können.
- Durchführen einer Montage des Trägerelements wahlweise zumindest an einer ersten oder zweiten Montageposition, wobei die Montagepositionen für unterschiedliche Seiten des Fahrzeuges spezifisch sind,
- Anschließen einer Verarbeitungsanordnung an eine Anschlussanordnung am Trägerelement, um die Funktionselemente mit der Verarbeitungsanordnung elektrisch zu verbinden, wobei die Anschlussanordnung eine Verbindungsschnittstelle zur Ansteuerung der Funktionselemente bereitstellt,
- Anpassen der Ansteuerung der Funktionselemente für die Zuordnung der Funktionen je nach ausgewählter Montageposition.

Damit bringt das erfindungsgemäße Verfahren die gleichen Vorteile mit sich, wie sie ausführlich mit Bezug auf eine erfindungsgemäße Anordnung beschrieben worden sind. Es kann zudem möglich sein, dass das Trägerelement mit den Funktionselementen und der Anschlussanordnung und insbesondere die Verarbeitungsanordnung entsprechend einer erfindungsgemäßen Anordnung ausgebildet sind.

Das Anpassen der Ansteuerung kann z. B. dadurch erfolgen, dass die Verarbeitungsanordnung die Ansteuerung über die Anschlussanordnung entsprechend der Funktionszuordnung durchführt (also z. B. ein bestimmtes der Funktionselemente gemäß der Erfassungsfunktion und das andere gemäß der Abschirmfunktion ansteuert). Auch kann es möglich sein, dass die Anpassung der Ansteuerung durch eine Anpassung der Verschaltung bei der Verbindungsschnittstelle erfolgt. Hierzu wird bspw. eine Gegenanschlussanordnung der Verarbeitungsanordnung von unterschiedlichen Außenseiten des Trägerelements angeschlossen.

Zudem ist es im Rahmen der Erfindung denkbar, dass die Montage an der ersten Montageposition in einen linksseitigen Türgriff des Fahrzeuges und an der zweiten Montageposition in einen rechtsseitigen Türgriff des Fahrzeuges erfolgt, um die Erfassungsfunktion als eine kapazitive Erfassung zur Detektion einer Aktivierungshandlung beim Fahrzeug bereitzustellen, und vorzugsweise eine Kommunikationsschnittstelle des Fahrzeuges zur Kommunikation mit einem ID-Geber (bspw. zur Authentifizierung) bereitzustellen. Der Türgriff kann dabei insbesondere als ein flächenbündiger Türgriff oder Muldengriff ausgebildet sein. Weiter kann gemäß der Erfassungsfunktion optional ein kantensensitiver Sensor bereitgestellt werden, bei welcher bei der Erfassung der Aktivierungshandlung eine Richtung unterschieden werden kann, von welcher eine Bewegung und/oder Annäherung zum Trägerelement erfolgt. Entsprechend kann zwischen einer Veränderung in der Umgebung an einer ersten oder einer zweiten Kante des Trägerelements unterschieden werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: eine schematische Draufsicht auf ein Fahrzeug mit einer erfindungsgemäßen Anordnung,
- Figur 2: eine schematische Seitenansicht auf ein Fahrzeug mit einer erfindungsgemäßen Anordnung,
- Figur 3: eine schematische Vorderansicht auf eine erfindungsgemäße Anordnung,
- Figur 4: eine weitere schematische Vorderansicht auf eine erfindungsgemäße Anordnung,
- Figur 5: eine schematische Rückansicht auf eine erfindungsgemäße Anordnung,
- Figur 6: ein schematisches Schaltbild zur Visualisierung der Verschaltung der Kommunikationsmittel einer erfindungsgemäßen Anordnung,
- Figur 7: ein weiteres schematisches Schaltbild zur Visualisierung der Verschaltung der Kommunikationsmittel einer erfindungsgemäßen Anordnung,
- Figur 8: eine schematische Darstellung einer Anschlussanordnung und einer damit verbundenen Gegenanschlussanordnung, und
- Figur 9: eine schematische Darstellung zur Visualisierung eines erfindungsgemäßen Verfahrens.

In den nachfolgenden Figuren werden für die gleichen technischen Merkmale auch von unterschiedlichen Ausführungsbeispielen die identischen Bezugszeichen verwendet.

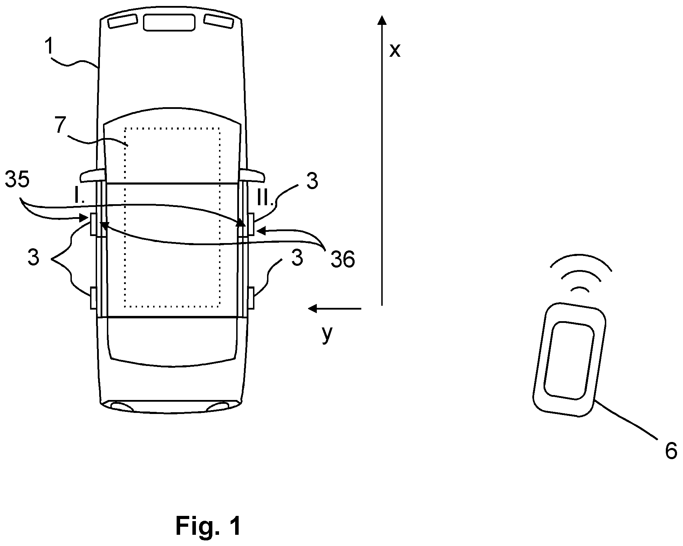

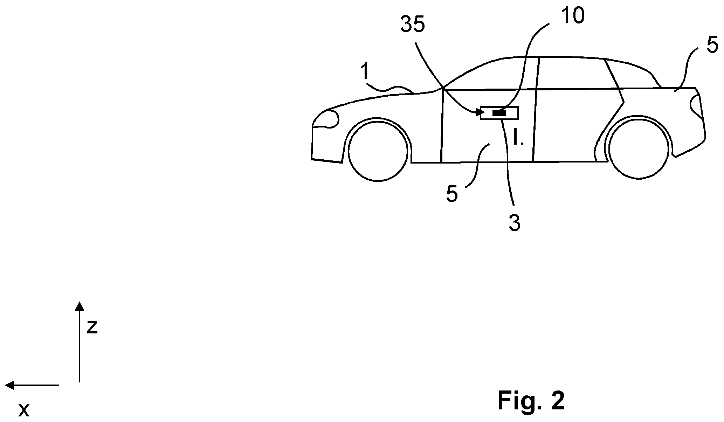

In Figur 1 ist ein Fahrzeug 1 mit wenigstens einer erfindungsgemäßen Anordnung 10 in einer Draufsicht gezeigt, wobei die Fahrzeugrichtungen x, y gekennzeichnet sind. In Figur 2 ist ebenfalls das Fahrzeug 1 gezeigt, allerdings in einer Seitenansicht entsprechend der gekennzeichneten Fahrzeugrichtungen x und z. In Figur 1 sind zwei Montagepositionen II des Fahrzeuges 1 dargestellt, wobei in Figur 2 die Draufsicht auf die erste Montageposition I erfolgt. Die erste Montageposition I kann die Position für einen linksseitig vorgesehenen Türgriff 3 am Fahrzeug 1 und eine zweite Montageposition II die Position für einen rechtsseitig vorgesehenen Türgriff 3 am Fahrzeug 1 bezeichnen. Alternativ können die Montagepositionen I, II auch die Positionen in dem jeweiligen Türgriff 3 bezeichnen, wobei der Türgriff 3 sich bei der Integration der Anordnung 10 in den Türgriff 3 noch nicht am Fahrzeug 1 befinden muss. Die Montage der erfindungsgemäßen Anordnung 10 kann somit z. B. zunächst in den Türgriff 3 erfolgen, und der Türgriff 3 dann an die entsprechende Position am Fahrzeug 1 montiert werden.

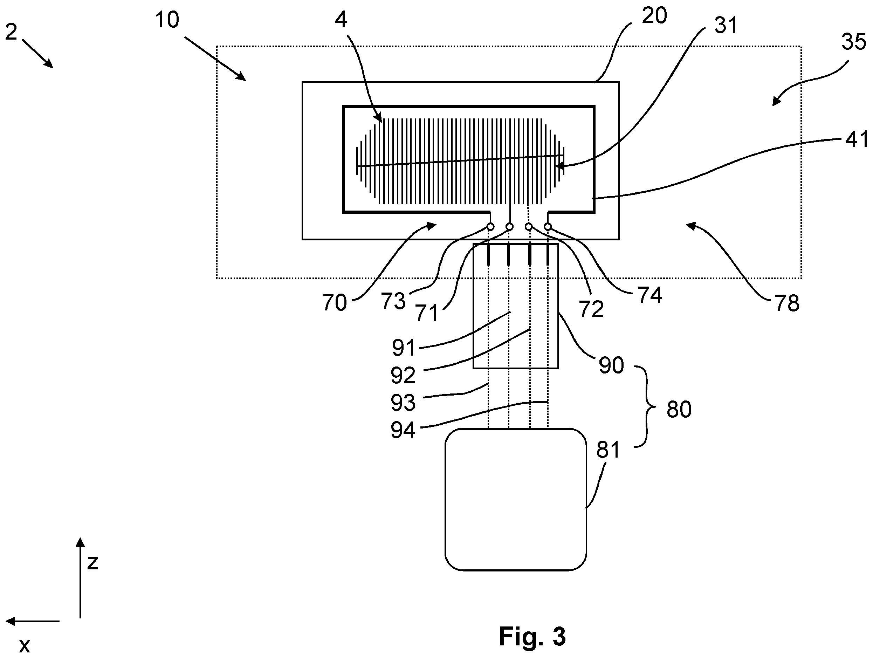

Figur 3 zeigt die erfindungsgemäße Anordnung 10 in der gleichen Ansicht wie in Figur 2. Es handelt sich dabei um eine Ansicht auf die Anordnung 10, wie sie entsprechend Figur 2 am Fahrzeug 1 an der ersten Montageposition I montiert sein kann. Die Fahrzeugrichtungen sind zur besseren Veranschaulichung des Aufbaus auch in Figur 3 angegeben, wobei in sämtlichen Figuren x eine Fahrzeuglängsachse (in Fahrzeugrichtung), y eine Fahrzeugquerachse und z eine Fahrzeughochachse bezeichnet. Um die Anordnung und die Kosten für die Herstellung und Montage zu reduzieren, kann es vorgesehen sein, dass für sämtliche Montagepositionen I, II nur ein gleiches Trägerelement 20 genutzt wird. Dieses kann zudem stets mit der gleichen Ausrichtung in den Richtungen x, y und z montiert werden. Daraus ergibt sich, dass für die unterschiedlichen Montagepositionen I, II unterschiedliche der Außenseiten 35, 36 des Trägerelements 20 dem Innenraum 7 zugewandt sind bzw. der Fahrzeugumgebung zugewandt sind (s. Figur 1). Die erste Außenseite 35 kann in der ersten Montageposition I somit dem Innenraum 7 abgewandt und in der Montageposition II dem Innenraum 7 zugewandt sein, wobei in beiden Montagepositionen II die Ausrichtung in x, y und z Richtung der in Figur 3 gezeigten Ausrichtung entspricht. Gedanklich wird das Trägerelement 20 also lediglich für den Wechsel von der ersten zur zweiten Montageposition II von links nach rechts am Fahrzeug verschoben.

Die erfindungsgemäße Anordnung 10 kann unterschiedliche Funktionen auf unterschiedlichen Seiten bereitstellen. An einer ersten Außenseite 35 des linksseitigen Türgriffs 3, also an der ersten Montageposition I, kann bspw. eine Erfassungsfunktion bereitgestellt werden. Hingegen kann an der ersten Außenseite 35 des rechtsseitigen Türgriffs 3, und somit an der zweiten Montageposition II, eine weitere Funktion wie eine Abschirmfunktion bereitgestellt werden. Ferner kann auf der zweiten Außenseite 36 der ersten Montageposition I die weitere Funktion und an der zweiten Außenseite 36 der zweiten Montageposition II die Erfassungsfunktion bereitgestellt werden. Wie aus den Darstellungen hervorgeht, kann somit eine Berücksichtigung der Montagepositionen I, II für die Funktionalität der erfindungsgemäßen Anordnung notwendig sein. Insbesondere kann diese Berücksichtigung als ein Funktionstausch und somit als eine Funktionszuordnung durchgeführt werden. Alternativ oder zusätzlich kann eine Kommunikationsfunktion auf beiden Außenseiten 35, 36 bereitgestellt sein, um stets einen von außerhalb des Fahrzeuges 1 nutzbaren Kommunikationsbereich zu erzeugen.

Entsprechend kann bei einer erfindungsgemäßen Anordnung 10 eine Anforderung hinsichtlich der Montagepositionen I, II definiert sein, dass die Funktionen, d. h. insbesondere die Erfassungs- und weitere Funktion, und/oder die Kommunikationsfunktion, an unterschiedlichen Seiten des Fahrzeuges 1 gleichartig vorgesehen sein müssen. Damit einhergehend kann eine weitere Anforderung hinsichtlich der Montagepositionen I, II definiert sein, dass die Funktionen in Bezug auf eine Fahrzeugmitte (und somit einem Innenraum 7 des Fahrzeuges) mit gleicher Ausrichtung und somit symmetrisch um die Fahrzeugmitte angeordnet sein müssen. Bspw. ermöglicht die Erfassungsfunktion, als eine Aktivierungshandlung eine Annäherung von außerhalb des Fahrzeuges 1 an den Türgriff zu detektieren. Hierzu muss allerdings ein Erfassungsfeld erzeugt werden, welches sich beim linksseitigen Türgriff 3 links vom Türgriff 3 und beim rechtsseitigen Türgriff 3 rechts vom Türgriff 3 befindet (vgl. Figur 1). Alternativ oder zusätzlich kann es erforderlich sein, dass eine Kommunikationsfunktion die Kommunikation mit einem ID-Geber 6 ermöglicht, unabhängig davon, welche Montageposition I, II für die Anordnung 10 gewählt wurde. Nach einer erfolgreichen Authentifizierung durch die Kommunikation kann z. B. die Aktivierung einer weiteren Aktivierungsfunktion des Fahrzeuges erfolgen, z. B. wenn die Erfassungsfunktion die Aktivierungshandlung detektiert. Hierbei kann es sich um eine Entriegelung oder Verriegelung oder Öffnungsbewegung einer Klappe 5 (wie einer Seitentür oder Seitenschiebetür oder einer Front- oder Heckklappe) des Fahrzeuges 1 handeln.

Um diesen Anforderungen gerecht zu werden, kann eine erfindungsgemäße Anordnung 10 zur Bereitstellung wenigstens einer Funktion für eine Elektronik 2 des Fahrzeuges 1 vorgesehen sein, vorzugsweise für eine Türgriffelektronik 2 des Fahrzeuges 1, bevorzugt für einen kapazitiven Sensor 4 zur Detektion einer Aktivierungshandlung beim Fahrzeug 1 und/oder für eine Kommunikationsschnittstelle 40 des Fahrzeuges 1 insbesondere zur Kommunikation mit einem ID-Geber.

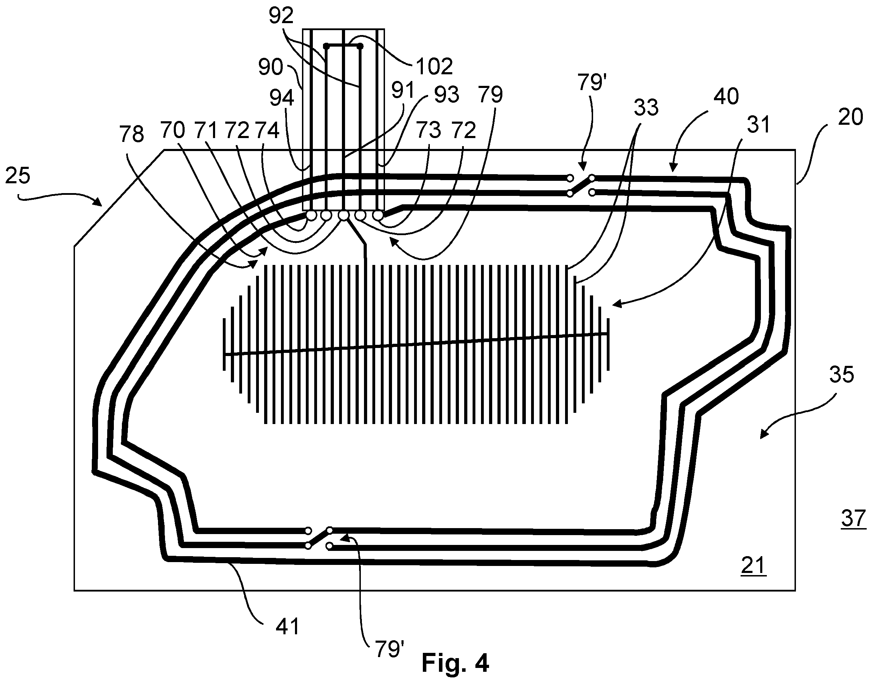

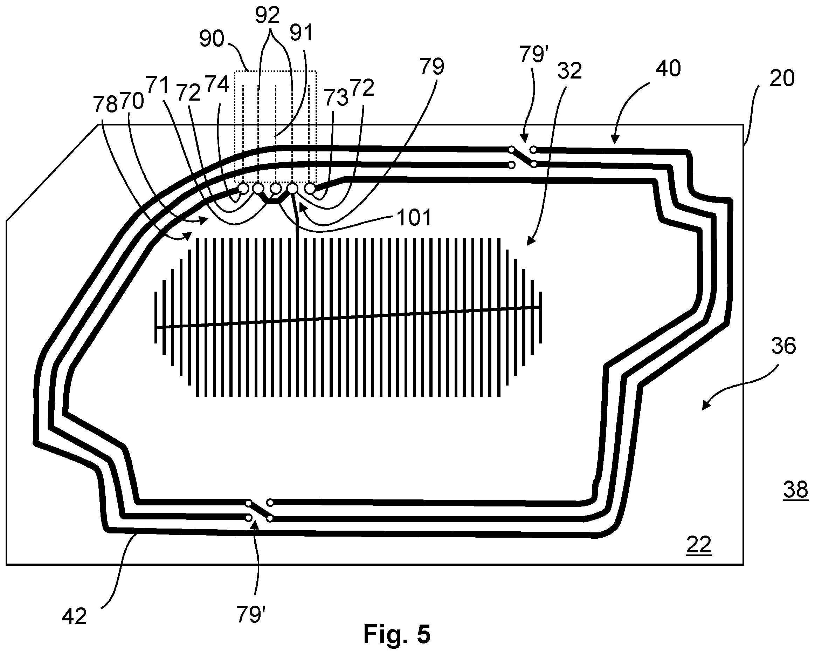

Es ist möglich, dass das Trägerelement 20 zur Montage an den Montagepositionen I, II auf unterschiedlichen Seiten des Fahrzeuges 1 geeignet ist, um wahlweise (also entsprechend einer Auswahl der Montageposition I, II) die Montage zumindest an einer ersten I oder zweiten II der Montagepositionen I, II durchzuführen. Dies ermöglicht es, die gleichen Trägerelemente 20 (d. h. gleich ausgebildete Trägerelemente 20) für unterschiedliche Montagepositionen I, II einsetzen zu können. Eine entsprechende Eignung weist das Trägerelement gemäß Figur 3, aber auch z. B. gemäß Figur 4 und 5 auf, da es sich in Türgriffen 3 für die linke und rechte Seiten montieren lässt. Dies wird bspw. durch eine entsprechende Anordnung von Befestigungsmitteln wie Schraubbohrungen und eine an die Türgriffe 3 angepasste Geometrie begünstigt. Darüber hinaus kann das Trägerelement 20 auch wenigstens eine an die Montagepositionen I, II derart angepasste Montageanpassung 25 aufweisen, dass die Montage an den Montagepositionen I, **II** mit gleicher Ausrichtung in Fahrzeuglängsrichtung x (und ggf. auch y, und z Richtung) durchführbar und insbesondere mit unterschiedlicher Ausrichtung in Fahrzeuglängsrichtung x verhindert ist.

Ferner kann eine erfindungsgemäße Anordnung 10 ein erstes elektrisch leitendes Funktionselement 31 an einer ersten Ebene 21 (s. Figuren 3 und 4) und ein zweites elektrisch leitendes Funktionselement 32 an einer zweiten Ebene 22 (s. Figur 5) des Trägerelements 20 aufweisen. Die Funktionselemente 31, 32 können dabei übereinander angeordnet und zumindest teilweise deckungsgleich ausgebildet sein, und sich ggf. auch tatsächlich zumindest teilweise geometrisch überdecken, um variabel zugeordnet für eine der Ebenen 21, 22 eine Erfassungsfunktion und für die andere der Ebenen 21, 22 eine weitere Funktion, insbesondere Abschirmfunktion, bereitzustellen. Die positionsgleiche und deckungsgleiche Ausbildung ist in den Figuren 4 und 5 für beide Funktionselemente 31, 32 bzw. Ebenen 21, 22 erkennbar. Bei der Kongruenz kommt dabei auf die für die Funktion wesentlichen Teile der Funktionselemente 31, 32 an, insbesondere die Flächenelemente 33, welche somit vollständig deckungsgleich sein können. Dies ermöglicht es, dass beide Funktionselemente 31, 32 im Wesentlichen die gleiche Funktion wahrnehmen können, und somit die Funktion austauschbar ist.

Darüber hinaus kann eine Anschlussanordnung 70 zur elektrischen Verbindung der Funktionselemente 31, 32 mit einer Verarbeitungsanordnung 80 vorgesehen sein, um eine Verbindungsschnittstelle 78 zur Ansteuerung der Funktionselemente 31, 32 für die Zuordnung der Funktionen je nach ausgewählter Montageposition I, II bereitzustellen. Insbesondere durch diese Funktionszuordnung kann der Funktionstausch erzielt werden. Die Verarbeitungsanordnung 70 kann zur Ansteuerung insbesondere eine Verarbeitungseinheit 81 wie einen Mikrocontroller oder dergleichen aufweisen.

Ferner kann es möglich sein, dass ein erstes Kommunikationsmittel 41 an einer ersten Ebene 21 des Trägerelements 20 angeordnet ist, und ein zweites Kommunikationsmittel 42 an einer zweiten Ebene 22 des Trägerelements 20 angeordnet ist, wobei die Kommunikationsmittel 41, 42 gegenüberliegend angeordnet und elektrisch parallel geschaltet sind, um wenigstens einen Kommunikationsbereich zu erzeugen, welcher für unterschiedliche ausgewählte Montagepositionen I, II geeignet ist. Eine entsprechende Ausbildung ist insbesondere in Figur 4 und 5 erkennbar. Die Kommunikationsmittel 41, 42 umgeben dabei die optionalen Funktionselemente 31, 32, wodurch sich eine kompakte und platzsparende Anordnung ergibt. Es kann eine (oder die) Anschlussanordnung 70 vorgesehen sein, um eine elektrische Verbindung der Kommunikationsmittel 41, 42 mit der Verarbeitungsanordnung 80 zu ermöglichen, um eine Verbindungsschnittstelle 78 zur Ansteuerung der Kommunikationsmittel 41, 42 bereitzustellen.

Des Weiteren ist gezeigt, dass die Kommunikationsmittel 41, 42 geometrisch parallel angeordnet sind, um ein Kommunikationsfeld, vorzugsweise ein magnetisches Feld, auf beiden der Ebenen 21, 22 symmetrisch zu erzeugen. Gezeigt sind in den Figuren 4 und 5 die Kommunikationsmittel 41, 42 jeweils in der Form einer Leiterbahn in Schleifenform, insbesondere einer Schleifenantenne bzw. einer Spule zur Nahfeldkommunikation.

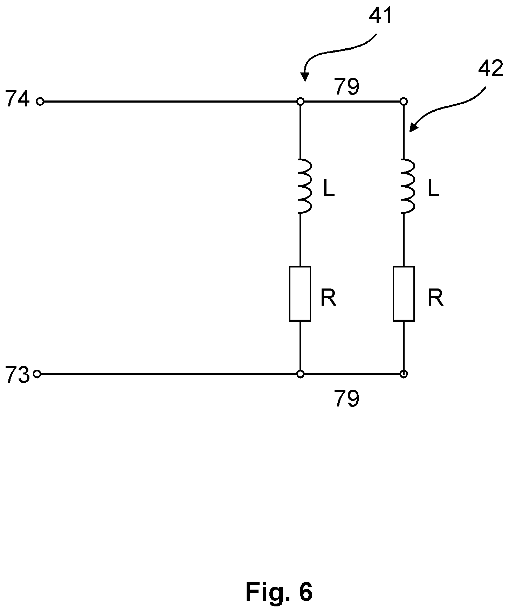

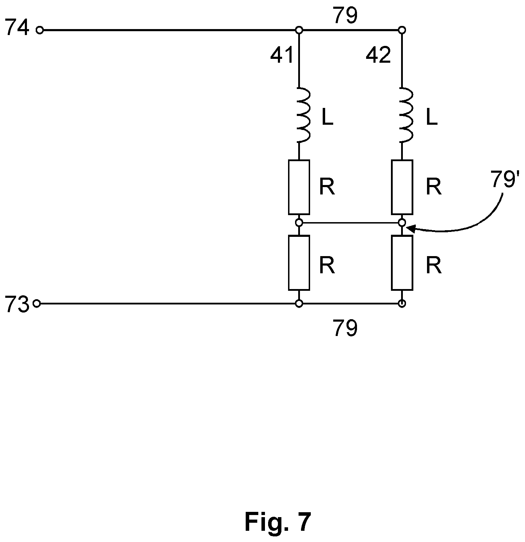

In Figur 6 und 7 ist jeweils ein schematisches Ersatzschaltbild der parallelgeschalteten Kommunikationsmittel 41, 42 gezeigt, welche jeweils eine Induktivität L und einen Widerstand R aufweisen. Der Widerstand R ist dabei spezifisch für den sogenannten Kupferverlust. Durch die gezeigte Parallelschaltung der Kommunikationsmittel 41, 42 über die Durchkontaktierungen 79 der Anschlussanordnung 70 kann dabei eine Reduktion dieses Kupferverlusts erzielt werden. Gleichzeitig kann durch die benachbarte Anordnung der beiden Kommunikationsmittel 41, 42 auf benachbarten Ebenen 21, 22 die magnetische Wechselwirkung zwischen den Kommunikationsmitteln 41, 42 die Verbesserung eines jeweiligen Kommunikationsfeldes zur Kommunikation erzielen, insbesondere Angleichung der räumlichen Erstreckung dieser Kommunikationsfelder. Um die Verlustleistung weiter zu reduzieren, kann gemäß Figur 7 zudem eine weitere Durchkontaktierung 79' vorgesehen sein, um die Kommunikationsmittel 41, 42 zusätzlich elektrisch miteinander zu verbinden.

Es ist in den Figuren 3 bis 5 gezeigt, dass die Anschlussanordnung 70 wenigstens ein erstes Anschlusselement 71 aufweist, welches mit dem ersten Funktionselement 31 elektrisch verbunden ist, um darüber variabel die Ansteuerung der Erfassungs- oder der weiteren Funktion beim ersten Funktionselement 31 bereitzustellen, und wenigstens ein zweites Anschlusselement 72 aufweist, welches mit dem zweiten Funktionselement 32 elektrisch verbunden ist, um darüber variabel die Ansteuerung der Erfassungs- oder der weiteren Funktion beim zweiten Funktionselement 32 bereitzustellen, und ein drittes 73 und viertes 74 Anschlusselement aufweist, welche mit einem ersten 41 und vorzugsweise einem zweiten 42 Kommunikationsmittel am Trägerelement 20 elektrisch verbunden sind, um darüber eine Ansteuerung einer Kommunikationsfunktion, vorzugsweise einer Nahfeldkommunikation, bevorzugt NFC, bereitzustellen.

Wie in Figur 4 und 5 gezeigt ist, können die Anschlussanordnung 70 und/oder Funktionselemente 31, 32 und/oder Kommunikationsmittel 41, 42 mehrere Durchkontaktierungen 79, 79' aufweisen. Die Durchkontaktierungen 79, 79' können mehrere Aufgaben erfüllen:
- Bereitstellen der Verbindungsschnittstelle 78 auf mehreren der Ebenen 21, 22, insbesondere sodass ein Anschließen auf beiden Außenseiten 35, 36 des Trägerelements 20 möglich ist, vorzugsweise durch die Durchkontaktierungen 79 der Anschlusselemente 71, 72, 73, 74
- Bereitstellen der Parallelschaltung der Kommunikationsmittel 41, 42, insbesondere durch die Durchkontaktierungen 79 der Anschlusselemente 73, 74,
- Bereitstellen einer zusätzlichen Verbindung der Kommunikationsmittel 41, 42 durch wenigstens eine weitere Durchkontaktierung 79'.

Die Verarbeitungsanordnung 80 und/oder die Anschlussanordnung 70 können zur Anpassung der Ansteuerung ausgeführt sein, um die Funktionszuordnung in der Art einer Festlegung durchzuführen, welches der Funktionselemente 31, 32 gemäß der Erfassungsfunktion angesteuert wird, und welches der Funktionselemente 31, 32 gemäß der weiteren Funktion angesteuert wird. Insbesondere kann die Anordnung 10 die Verarbeitungsanordnung 80 aufweisen, wobei die Verarbeitungsanordnung 80 dazu ausgeführt ist, über das erste Anschlusselement 71 das erste Funktionselement 31 und über das zweite Anschlusselement 72 das zweite Funktionselement 32 anzusteuern, wobei die Verarbeitungsanordnung 80 und/oder die Anschlussanordnung 70 zur Anpassung der Ansteuerung für die Funktionszuordnung derart ausgeführt ist, dass die Funktionszuordnung eine erste Zuordnung für die erste Montageposition I und eine zweite Zuordnung für die zweite Montageposition II umfasst, um bei der ersten Zuordnung
- die Erfassungsfunktion über das erste Anschlusselement 71 und die weitere Funktion über das zweite Anschlusselement 72 anzusteuern, um insbesondere die Erfassungsfunktion in der Art einer Erfassung in einer ersten Umgebung 37 des ersten Funktionselements 31 und die weitere Funktion in der Art einer Abschirmung des ersten Funktionselement 31 von einer zweiten Umgebung 38 des zweiten Funktionselements 32 durchzuführen,
und um bei der zweiten Zuordnung
- die Erfassungsfunktion über das zweite Anschlusselement 72 und die weitere Funktion über das erste Anschlusselement 71 anzusteuern, um insbesondere die Erfassungsfunktion in der Art der Erfassung in der zweiten Umgebung 38 des zweiten Funktionselements 32 und die weitere Funktion in der Art der Abschirmung des zweiten Funktionselement 32 von einer ersten Umgebung 37 des ersten Funktionselements 31 durchzuführen,
sodass die Erfassung und Abschirmung je nach Montageposition I, II auf unterschiedlichen der Ebenen 21, 22 und unterschiedlicher der Umgebungen 37, 38 durchgeführt werden.

Die Anschlussanordnung 70 kann zur Anpassung der Ansteuerung für die Funktionszuordnung außerdem in der Art ausgeführt sein, dass die Anschlusselemente 71, 72 zur elektrischen Verbindung mit unterschiedlichen Gegenanschlusselementen 91, 92 der Verarbeitungsanordnung 80 geeignet sind, um die Funktionszuordnung durch eine Zuordnung der Gegenanschlusselemente 91, 92 zu den Anschlusselementen 71, 72 vorzunehmen. Bspw. ist in Figur 3 gezeigt, dass eine bestimmte Reihenfolge 71, 72, 73 ,74 der Anschlusselemente bei der Anschlussanordnung 70, aber auch eine vorgegebene Reihenfolge 91, 92, 93, 94 der Gegenanschlusselemente bei der Gegenanschlussanordnung 90 vorgesehen sein kann. Die Anschlusselemente 71, 72, 73, 74 können beidseitig anschließbar sein, z. B. durch die Nutzung von Durchkontaktierungen. Die Gegenanschlussanordnung 90 kann hierbei als Steckverbinder oder dergleichen ausgebildet sein, sodass die Reihenfolge mechanisch vorgegeben ist. Damit erfolgt aufgrund des "Umdrehens" der Gegenanschlussanordnung 90 das Anschließen von der ersten Außenseite 35 mit einer anderen Anschlusskonfiguration als von der zweiten Außenseite 36. Da die Anschlusselemente 73, 74 außenliegend angeordnet sind, ist es für den Anschluss des Kommunikationsmittels 41, 42 (also der Kommunikationsschnittstelle 40) funktional nicht relevant, ob die Anschlusselemente 73, 74 in der ersten Montageposition I von der ersten 35 oder in der zweiten Montageposition II von der zweiten Außenseite 36 mit den Gegenanschlusselemente 93, 94 verbunden werden. Hingegen ist es anhand Figur 3 ersichtlich, dass in der zweiten Montageposition II bei einem Anschließen von der zweiten Außenseite 36 anstelle des ersten Anschlusselementes 71 (in der ersten Montageposition I bei dem Anschließen von der ersten Außenseite 35) das zweite Anschlusselement 72 mit dem ersten Gegenanschlusselement 91 verbunden wird, und anstelle des zweiten Anschlusselements 72 in der ersten Montageposition I das erste Anschlusselement 71 mit dem zweiten Gegenanschlusselement 92 verbunden wird. Dies ermöglicht eine mechanische Anpassung der Anschlusskonfiguration und somit auch der Ansteuerung der Funktionselemente 31, 32. Alternativ und/oder zusätzlich kann eine Anpassung der Ansteuerung elektrisch durch die Verarbeitungsanordnung 80 durchgeführt werden, insbesondere bei gleichbleibender Zuordnung der Anschlusselemente zu den Gegenanschlusselementen. Dann wird z. B. je nach Montageposition I, II die Ansteuerung der Erfassungsfunktion entweder über das erste oder zweite Gegenanschlusselement 91, 92 erfolgen, und das jeweils andere Gegenanschlusselement 92, 91 für die weitere Funktion angesteuert werden.

Des Weiteren ist in Figur 4 und 5 gezeigt, dass die Gegenanschlusselemente 91 bis 94, insbesondere als Flachbandkabel, im rechten Winkel die Leiterbahnen der Kommunikationsmittel 41, 42 kreuzen. Damit kann eine Störung durch wenigstens eines der Gegenanschlusselemente 91 bis 94 auf das Kommunikationsfeld zumindest reduziert werden. Das erste und/oder zweite Verbindungselement 101, 102 kann jeweils auch als Kurzschlussbrücke verstanden werden. Die Kurzschlussbrücke 101 und/oder 102 kann zumindest teilweise parallel und/oder phasenrichtig zur Leiterbahn verlaufen. Somit wirkt auch die Kurzschlussbrücke 101 bzw. 102 nicht störend, z. B. wirkt nicht zusätzlich als ein Kommunikationsmittel.

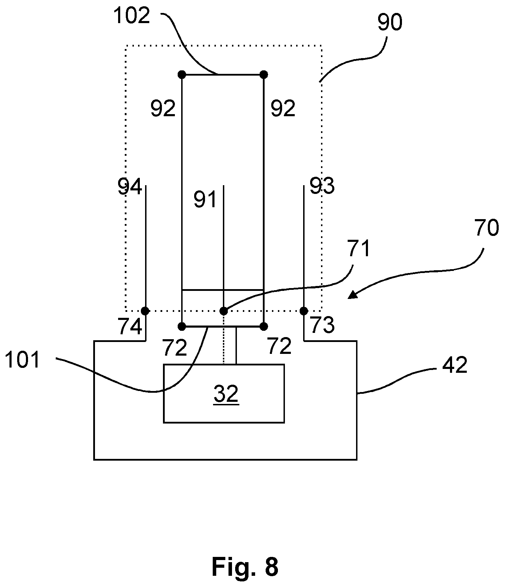

In Figur 8 ist eine Anschlussanordnung 70 sowie eine Gegenanschlussanordnung 90 mit weiteren Einzelheiten gezeigt. Die Anschlussanordnung 70 kann am Trägerelement 20 befestigt sein, und/oder die Gegenanschlussanordnung 90 kann - insbesondere in der Form eines Flachbandkabels - zum Anschluss an die Anschlussanordnung 70 vorgesehen sein. Dabei kann die Gegenanschlussanordnung 90 nachfolgendes aufweisen:
- das erste Gegenanschlusselement 91, welches einen Strompfad für eine Ansteuerung wenigstens einer Funktion der Anordnung 10 bereitstellt,
- das wenigstens eine zweite Gegenanschlusselement 92, wobei in Figur 8 zwei zweite Gegenanschlusselemente 92 gezeigt sind, um gemeinsam einen Strompfad für eine Ansteuerung wenigstens einer weiteren Funktion der Anordnung 10 bereitzustellen,
- wenigstens das dritte und vierte Gegenanschlusselement 93, 94, um für eine Ansteuerung der Kommunikationsfunktion einen Stromkreis mit den Kommunikationsmitteln 41, 42 auszubilden.

Dabei können die Gegenanschlusselemente 91, 92, 93, 94 zumindest teilweise räumlich parallel und nebeneinander angeordnet sein, und das erste Gegenanschlusselement 91 (insbesondere mittig und/oder zentriert) zwischen den zweiten Gegenanschlusselementen 92 angeordnet sein, und die zweiten Gegenanschlusselemente 92 zwischen den dritten und vierten Gegenanschlusselementen 93, 94 angeordnet sein. Die dritten und vierten Gegenanschlusselemente 93, 94 können zudem außenliegend bei der Gegenanschlussanordnung 90 angeordnet sein. Ferner können die zweiten Gegenanschlusselemente 92 über zwei Verbindungselemente 101, 102 miteinander elektrisch verbunden sein, wobei das erste Verbindungselement 101 im Bereich der Anschlussanordnung 70 und das zweite Verbindungselement 102 im Bereich der Gegenanschlussanordnung 90 angeordnet sein kann. Auf diese Weise kann ein Kompensationsstromkreis zur Reduzierung oder Verhinderung des Kommunikationsbereichs im Bereich der Gegenanschlussanordnung 90 bereitgestellt werden. Insbesondere dieser Bereich zwischen dem ersten 101 und zweiten 102 der Verbindungselemente kann somit nicht zur Kommunikation genutzt werden. Der durch die Pfade 92, 101 und 102 gebildete Kompensationsschaltkreis kompensiert (neutralisiert) dabei die magnetischen Felder, welche im Bereich der dritten und vierten Gegenanschlusselemente 93, 94 erzeugt werden. Vorzugsweise ist hierzu vorgesehen, dass die Gegenanschlusselemente 91, 92, 93, 94 in einem gleichen Abstand voneinander angeordnet sind. Bevorzugt sind die Gegenanschlusselemente 91, 92, 93, 94 als langgestreckte Leiter ausgebildet, bevorzugt als Leitungen.

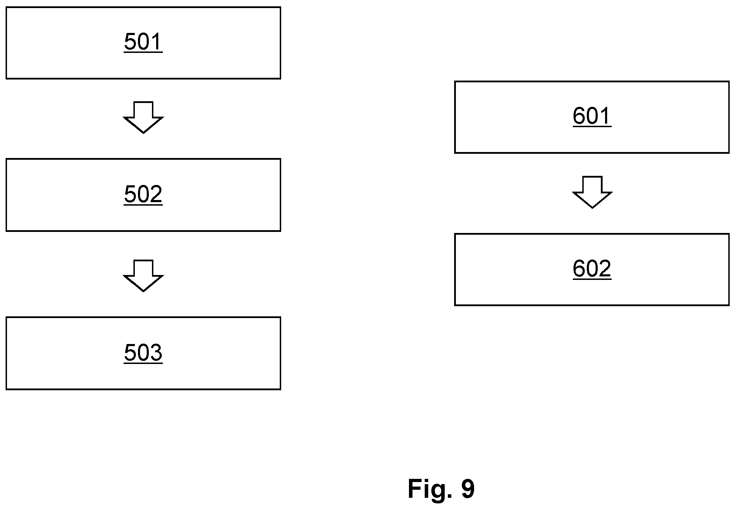

In Figur 9 ist ein erfindungsgemäßes Verfahren schematisch visualisiert. Dabei kann vorgesehen sein, dass gemäß einem ersten Verfahrensschritt 501 ein Durchführen einer Montage des Trägerelements 20 wahlweise zumindest an einer ersten I oder zweiten II Montageposition erfolgt, wobei die Montagepositionen I, II für unterschiedliche Seiten des Fahrzeuges 1 spezifisch sind. Gemäß einem zweiten Verfahrensschritt 502 kann ein Anschließen einer Verarbeitungsanordnung 80 an eine Anschlussanordnung 70 am Trägerelement 20 erfolgen, um die Funktionselemente 31, 32 mit der Verarbeitungsanordnung 80 elektrisch zu verbinden, wobei die Anschlussanordnung 70 eine Verbindungsschnittstelle 78 zur Ansteuerung der Funktionselemente 31, 32 bereitstellt. Anschließend kann gemäß einem dritten Verfahrensschritt 503 ein Anpassen der Ansteuerung der Funktionselemente 31, 32 für die Zuordnung der Funktionen je nach ausgewählter Montageposition I, II erfolgen.

Hinsichtlich der Kommunikationsfunktion kann gemäß Figur 9 alternativ oder zusätzlich vorgesehen sein, dass gemäß einem weiteren ersten Verfahrensschritt 601 eine Montage des Trägerelements 20 wahlweise zumindest an einer ersten I oder zweiten II der Montagepositionen erfolgt, und gemäß einem weiteren zweiten Verfahrensschritt 602 ein Anschließen einer Verarbeitungsanordnung 80 an eine Anschlussanordnung 70 am Trägerelement 20 durchgeführt wird, um die Kommunikationsmittel 41, 42 mit der Verarbeitungsanordnung 80 elektrisch zu verbinden, wobei die Anschlussanordnung 70 eine Verbindungsschnittstelle 78 zur Ansteuerung der Kommunikationsfunktion bereitstellt.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 2: Elektronik, Türgriffelektronik
- 3: Türgriff, Griff
- 4: kapazitiver Sensor
- 5: Tür, Klappe
- 6: ID-Geber
- 7: Innenraum

- 10: Anordnung

- 20: Trägerelement
- 21: erste Ebene
- 22: zweite Ebene
- 25: Montageanpassung

- 31: erstes Funktionselement
- 32: zweites Funktionselement
- 33: Flächenelemente
- 35: erste Außenseite, erste Seitenfläche
- 36: zweite Außenseite, zweite Seitenfläche
- 37: erste Umgebung
- 38: zweite Umgebung

- 40: Kommunikationsschnittstelle
- 41: erstes Kommunikationsmittel, NFC-Antenne bzw. Spule
- 42: zweites Kommunikationsmittel, NFC-Antenne bzw. Spule

- 70: Anschlussanordnung
- 71: erstes Anschlusselement
- 72: zweites Anschlusselement, funktionsgleiche Anschlusselemente
- 73: drittes Anschlusselement
- 74: viertes Anschlusselement
- 78: Verbindungsschnittstelle
- 79: Durchkontaktierung

- 80: Verarbeitungsanordnung, Teil einer Zuleitung
- 81: Verarbeitungseinheit

- 90: Gegenanschlussanordnung, Teil einer Zuleitung
- 91: erstes Gegenanschlusselement
- 92: zweites Gegenanschlusselement
- 93: drittes Gegenanschlusselement
- 94: viertes Gegenanschlusselement

- 101: erstes Verbindungselement, Kurzschlussbrücke
- 102: zweites Verbindungselement, Kurzschlussbrücke

- 501: erster Verfahrensschritt
- 502: zweiter Verfahrensschritt
- 503: dritter Verfahrensschritt
- 504: weiterer erster Verfahrensschritt
- 505: weiterer zweiter Verfahrensschritt

- 79': weitere Durchkontaktierung
- 21, 22: Ebenen
- 31, 32: Funktionselemente
- 35, 36: Außenseiten
- 37, 38: Umgebungen
- 41, 42: Kommunikationsmittel
- 71, 72: Anschlusselemente, innenliegende Anschlusselemente
- 73, 74: außenliegenden Anschlusselementen
- 91, 92: Gegenanschlusselemente
- x: Fahrzeuglängsachse, Fahrrichtung, Fahrzeuglängsrichtung
- y: Fahrzeugquerachse
- z: Fahrzeughochachse
- I: erste Montageposition
- II: zweite Montageposition
- I, II: Montagepositionen
- L: Spule
- R: Widerstand

## Patentansprüche

1. Anordnung (10) zur Bereitstellung wenigstens einer Funktion für eine Elektronik (2) eines Fahrzeuges (1), vorzugsweise für eine Türgriffelektronik (2) des Fahrzeuges (1), bevorzugt für einen kapazitiven Sensor (4) zur Detektion einer Aktivierungshandlung beim Fahrzeug (1) und/oder für eine Kommunikationsschnittstelle (40) des Fahrzeuges (1),
aufweisend:
- ein Trägerelement (20), welches zur Montage an Montagepositionen (I, II) auf unterschiedlichen Seiten des Fahrzeuges (1) geeignet ist, um wahlweise die Montage zumindest an einer ersten (I) oder zweiten (II) der Montagepositionen (I, II) durchzuführen,
- ein erstes elektrisch leitendes Funktionselement (31) an einer ersten Ebene (21) und ein zweites elektrisch leitendes Funktionselement (32) an einer zweiten Ebene (22) des Trägerelements (20), wobei die Funktionselemente (31, 32) übereinander angeordnet und zumindest teilweise deckungsgleich ausgebildet sind, um variabel zugeordnet für eine der Ebenen (21, 22) eine Erfassungsfunktion und für die andere der Ebenen (21, 22) eine weitere Funktion, insbesondere Abschirmfunktion, bereitzustellen,
- eine Anschlussanordnung (70) zur elektrischen Verbindung der Funktionselemente (31, 32) mit einer Verarbeitungsanordnung (80), um eine Verbindungsschnittstelle (78) zur Ansteuerung der Funktionselemente (31, 32) für die Zuordnung der Funktionen je nach ausgewählter Montageposition (I, II) bereitzustellen,
**dadurch gekennzeichnet,**
**dass** die Anschlussanordnung (70) zur Anpassung der Ansteuerung für die Funktionszuordnung in der Art ausgeführt ist, dass die Verbindungsschnittstelle (78) auf den Ebenen (21, 22) jeweils unterschiedlich bereitgestellt ist, um je nach ausgewählter Montageposition (I, II) eine unterschiedliche Zuordnung von Gegenanschlusselementen (91, 92) der Verarbeitungsanordnung (80) zu Anschlusselementen (71, 72) der Anschlussanordnung (70) vorzunehmen.

2. Anordnung (10) nach Anspruch 1,
**dadurch gekennzeichnet,**
**dass** die Verarbeitungsanordnung (80) und/oder die Anschlussanordnung (70) zur Anpassung der Ansteuerung ausgeführt ist, um die Funktionszuordnung in der Art einer Festlegung durchzuführen, welches der Funktionselemente (31, 32) gemäß der Erfassungsfunktion angesteuert wird, und welches der Funktionselemente (31, 32) gemäß der weiteren Funktion angesteuert wird.

3. Anordnung (10) nach Anspruch 1 oder 2,
**dadurch gekennzeichnet,**
**dass** die Verarbeitungsanordnung (80) dazu ausgeführt ist, über wenigstens ein erstes Anschlusselement (71) der Anschlussanordnung (70) das erste Funktionselement (31) und über wenigstens ein zweites Anschlusselement (72) der Anschlussanordnung (70) das zweite Funktionselement (32) anzusteuern, wobei die Verarbeitungsanordnung (80) und/oder die Anschlussanordnung (70) zur Anpassung der Ansteuerung für die Funktionszuordnung derart ausgeführt ist, dass die Funktionszuordnung eine erste Zuordnung für die erste Montageposition (I) und eine zweite Zuordnung für die zweite Montageposition (II) umfasst, um bei der ersten Zuordnung
- die Erfassungsfunktion über das erste Anschlusselement (71) und die weitere Funktion über das zweite Anschlusselement (72) anzusteuern, um insbesondere die Erfassungsfunktion in der Art einer Erfassung in einer ersten Umgebung (37) des ersten Funktionselements (31) und die weitere Funktion in der Art einer Abschirmung des ersten Funktionselements (31) von einer zweiten Umgebung (38) des zweiten Funktionselements (32) durchzuführen,
und um bei der zweiten Zuordnung
- die Erfassungsfunktion über das zweite Anschlusselement (72) und die weitere Funktion über das erste Anschlusselement (71) anzusteuern, um insbesondere die Erfassungsfunktion in der Art der Erfassung in der zweiten Umgebung (38) des zweiten Funktionselements (32) und die weitere Funktion in der Art der Abschirmung des zweiten Funktionselements (32) von einer ersten Umgebung (37) des ersten Funktionselements (31) durchzuführen,
sodass vorzugsweise die Erfassung und Abschirmung je nach Montageposition (I, II) auf unterschiedlichen der Ebenen (21, 22) und unterschiedlicher der Umgebungen (37, 38) durchgeführt werden.

4. Anordnung (10) nach einem der vorhergehenden Ansprüche,
**dadurch gekennzeichnet,**
**dass** die Anschlussanordnung (70) zur Anpassung der Ansteuerung für die Funktionszuordnung in der Art ausgeführt ist, dass die Anschlussanordnung (70) wenigstens ein erstes Anschlusselement (71) aufweist, das mit dem ersten Funktionselement (31) elektrisch verbunden ist, und wenigstens ein zweites Anschlusselement (72) aufweist, das mit dem zweiten Funktionselement (32) elektrisch verbunden ist, wobei die Anschlusselemente (71, 72) zur elektrischen Verbindung mit unterschiedlichen Gegenanschlusselementen (91, 92) der Verarbeitungsanordnung (80) geeignet sind, um die Funktionszuordnung durch eine Zuordnung der Gegenanschlusselemente (91, 92) zu den Anschlusselementen (71, 72) vorzunehmen.

5. Anordnung (10) nach einem der vorhergehenden Ansprüche,
**dadurch gekennzeichnet,**
**dass** die Anordnung (10) die Verarbeitungsanordnung (80) aufweist, wobei die Verarbeitungsanordnung (80) zur Anpassung der Ansteuerung für die Funktionszuordnung in der Art ausgeführt ist, dass die Verarbeitungsanordnung (80) wahlweise das erste Funktionselement (31) oder das zweite Funktionselement (32) gemäß der Erfassungsfunktion ansteuert, und das andere der Funktionselemente (31, 32) gemäß der weiteren Funktion ansteuert.

6. Anordnung (10) nach einem der vorhergehenden Ansprüche,
**dadurch gekennzeichnet,**
**dass** die Anschlussanordnung (70) wenigstens zwei Anschlusselemente (71, 72) aufweist, welche zur Bereitstellung der Verbindungsschnittstelle (78) auf beiden Ebenen (21, 22) jeweils beidseitig zur Verbindung mit einem Gegenanschlusselement (91, 92) der Verarbeitungsanordnung (80) ausgebildet sind, vorzugsweise zum lösbaren Verbinden der Funktionselemente (31, 32) an unterschiedlichen Außenseiten (35, 36) des Trägerelements (20), wobei bevorzugt die Anschlusselemente (71, 72) hierzu wenigstens eine Durchkontaktierung (79) aufweisen.
und/oder dass die Anschlussanordnung (70) beidseitig am Trägerelement (20) die Verbindungsschnittstelle (78) aufweist, um entsprechend der unterschiedlichen Montagepositionen (I, II) wenigstens ein Gegenanschlusselement (91, 92) wahlweise an einer der beiden Außenseiten (35, 36) des Trägerelements (20) an die Verbindungsschnittstelle (78) anzuschließen, und insbesondere um die Funktionszuordnung in Abhängigkeit von der ausgewählten Außenseite (35, 36) vorzunehmen, an welcher der Anschluss erfolgt.

7. Anordnung (10) nach einem der vorhergehenden Ansprüche,
**dadurch gekennzeichnet,**
**dass** die Anschlussanordnung (70) wenigstens ein erstes Anschlusselement (71) aufweist, welches mit dem ersten Funktionselement (31) elektrisch verbunden ist, um darüber variabel die Ansteuerung der Erfassungs- oder der weiteren Funktion beim ersten Funktionselement (31) bereitzustellen, und wenigstens ein zweites Anschlusselement (72) aufweist, welches mit dem zweiten Funktionselement (32) elektrisch verbunden ist, um darüber variabel die Ansteuerung der Erfassungs- oder der weiteren Funktion beim zweiten Funktionselement (32) bereitzustellen, und ein drittes (73) und viertes (74) Anschlusselement aufweist, welche mit einem ersten (41) und vorzugsweise einem zweiten (42) Kommunikationsmittel am Trägerelement (20) elektrisch verbunden sind, um darüber eine Ansteuerung einer Kommunikationsfunktion, vorzugsweise einer Nahfeldkommunikation, bevorzugt NFC, bereitzustellen.

8. Anordnung (10) nach einem der vorhergehenden Ansprüche,
**dadurch gekennzeichnet,**
**dass** die Funktionselemente (31, 32) sich im Wesentlichen und/oder zumindest überwiegend geometrisch überdecken, um die weitere Funktion als zumindest einseitige Abschirmung der Erfassungsfunktion bereitzustellen,
und/oder dass die Funktionselemente (31, 32) positionsgleich und insbesondere deckungsgleich auf den jeweiligen Ebenen (21, 22) angeordnet sind, sodass die Erfassungsfunktion unabhängig von der Auswahl der Montageposition (I, II) in gleicher Weise jedoch für unterschiedliche Umgebungen (37, 38) bereitgestellt ist, insbesondere gleich hinsichtlich der Position und Erstreckung eines durch die Funktionselemente (31, 32) erzeugten elektrischen Feldes.

9. Anordnung (10) nach einem der vorhergehenden Ansprüche,
**dadurch gekennzeichnet,**
**dass** das Trägerelement (20) zur Montage an den Montagepositionen (I, II) auf gegenüberliegenden Seiten des Fahrzeuges (1) ausgeführt ist, und eine an die Montagepositionen (I, II) derart angepasste Montageanpassung (25) aufweist, dass die Montage an den Montagepositionen (I, II) mit gleicher Ausrichtung in Fahrzeuglängsrichtung (x) durchführbar und insbesondere mit unterschiedlicher Ausrichtung in Fahrzeuglängsrichtung (x) verhindert ist, vorzugsweise sodass bei der Montage an der ersten Montageposition (I) die erste Ebene (21) einem Innenraum (7) des Fahrzeuges (1) abgewandt und die zweite Ebene (22) dem Innenraum (7) zugewandt ist, und bei der Montage an der zweiten Montageposition (II) die zweite Ebene (22) dem Innenraum (7) abgewandt und die erste Ebene (21) dem Innenraum (7) zugewandt ist, um insbesondere die Erfassungs- und weitere Funktion symmetrisch am Fahrzeug (1) bereitzustellen,
und/oder dass das Trägerelement (20) als eine mindestens oder genau zweiseitige Leiterplatte ausgebildet ist, um eine beidseitige Aufnahme der Funktionselemente (31, 32) bereitzustellen, bei welcher das erste Funktionselement (31) an einer ersten Außenseite (35) des Trägerelements (20) und das zweite Funktionselement (32) an einer gegenüberliegenden zweiten Außenseite (36) des Trägerelements (20) befestigt ist, um die Erfassungs- und weitere Funktion auf unterschiedlichen Außenseiten (35, 36) bereitzustellen.

10. Anordnung (10) nach einem der vorhergehenden Ansprüche,
**dadurch gekennzeichnet,**
**dass** die Funktionselemente (31, 32) jeweils sowohl als eine kapazitive Sensorelektrode zur Bereitstellung der Erfassungsfunktion als auch als eine Abschirmungselektrode zur Bereitstellung der weiteren Funktion ausgebildet sind, um die Funktionen je nach Funktionszuordnung und ausgewählter Montageposition (I, II) bereitzustellen, wobei die Funktionselemente (31, 32) hierzu jeweils geometrisch gleich mit einer flächigen Form ausgebildet sind, und bevorzugt beabstandete Flächenelemente (33), insbesondere Rippen, zur Verringerung von Wirbelstromverlusten bei einer benachbarten und die Funktionselemente (31, 32) umgebende Kommunikationsschnittstelle (40) aufweisen.

11. Anordnung (10) nach einem der vorhergehenden Ansprüche,
**dadurch gekennzeichnet,**
**dass** die Verarbeitungsanordnung (80) dazu ausgeführt ist, über die Anschlussanordnung (70) die Funktionselemente (31, 32) zur kapazitiven Erfassung und eine die Funktionselemente (31, 32) umgebende Kommunikationsschnittstelle (40) zur Nahfeldkommunikation alternierend anzusteuern.

12. Anordnung (10) nach einem der vorhergehenden Ansprüche,
**dadurch gekennzeichnet,**
**dass** das Trägerelement (20) als eine Leiterplatte mit den wenigstens oder genau zwei Ebenen (21, 22), insbesondere als eine Mehrlagenplatine, ausgebildet ist, wobei eine Anschlussanordnung (70) auf beiden Ebenen (21, 22), insbesondere mittels wenigstens einer Durchkontaktierung (79), angeordnet ist.

13. Verfahren zur Bereitstellung wenigstens einer Funktion für eine Elektronik (2) eines Fahrzeuges (1) durch eine Anordnung (10) gemäß einem der vorhergehenden Ansprüche, wobei das erstes und das zweites elektrisch leitendes Funktionselement (31, 32) an die unterschiedlichen Ebenen (21, 22) des Trägerelements (20) vorgesehen sind, um variabel zugeordnet für eine der Ebenen (21, 22) die Erfassungsfunktion und für die andere der Ebenen (21, 22) die weitere Funktion bereitzustellen, **wobei die nachfolgenden Schritte durchgeführt werden:**
- Durchführen einer Montage des Trägerelements (20) wahlweise zumindest an der ersten (I) oder zweiten (II) Montageposition, wobei die Montagepositionen (I, II) für unterschiedliche Seiten des Fahrzeuges (1) spezifisch sind,
- Anschließen der, Verarbeitungsanordnung (80) an die Anschlussanordnung (70) am Trägerelement (20), um die Funktionselemente (31, 32) mit der Verarbeitungsanordnung (80) elektrisch zu verbinden, wobei die Anschlussanordnung (70) die Verbindungsschnittstelle (78) zur Ansteuerung der Funktionselemente (31, 32) bereitstellt,
- Anpassen der Ansteuerung der Funktionselemente (31, 32) für die Zuordnung der Funktionen je nach ausgewählter Montageposition (I, II).

14. Verfahren nach einem der vorhergehenden Ansprüche,
**dadurch gekennzeichnet,**
**dass** die Montage an der ersten Montageposition (I) in einen linksseitigen Türgriff (3) des Fahrzeuges (1) und an der zweiten Montageposition (II) in einen rechtsseitigen Türgriff (3) des Fahrzeuges (1) erfolgt, um die Erfassungsfunktion als eine kapazitive Erfassung zur Detektion einer Aktivierungshandlung beim Fahrzeug (1) bereitzustellen, und vorzugsweise eine Kommunikationsschnittstelle (40) des Fahrzeuges (1) zur Kommunikation mit einem ID-Geber (6) bereitzustellen.

15. Verfahren nach einem der vorhergehenden Ansprüche,
**dadurch gekennzeichnet,**
**dass** das Trägerelement (20) mit den Funktionselementen (31, 32) und der Anschlussanordnung (70) und insbesondere die Verarbeitungsanordnung (80) entsprechend einer Anordnung (10) nach einem der vorhergehenden Ansprüche ausgebildet sind.

## Claims

1. Arrangement (10) for providing at least one function for an electronic system (2) of a vehicle (1), preferably for a door handle electronic system (2) of the vehicle (1), preferably for a capacitive sensor (4) for detecting an activation action in the vehicle (1) and/or for a communication interface (40) of the vehicle (1),
comprising:
- a carrier element (20) which is suitable for mounting at mounting positions (I, II) on different sides of the vehicle (1) in order to carry out the mounting optionally at least at a first (I) or second (II) of the mounting positions (I, II),
- a first electrically conductive functional element (31) on a first plane (21) and a second electrically conductive functional element (32) on a second plane (22) of the carrier element (20), wherein the functional elements (31, 32) are arranged one above the other and are at least partially congruent in order to provide a detection function variably assigned for one of the planes (21, 22) and a further function, in particular a shielding function, for the other of the planes (21, 22),
- a connection arrangement (70) for the electrical connection of the functional elements (31, 32) to a processing arrangement (80) in order to provide a connection interface (78) for controlling the functional elements (31, 32) for the assignment of the functions depending on the selected mounting position (I, II),
**characterized in that**
the connection arrangement (70) for adapting the control for the function assignment is designed in such a way that the connection interface (78) is provided differently in each case on the planes (21, 22) in order to carry out a different assignment of mating connection elements (91, 92) of the processing arrangement (80) to connection elements (71, 72) of the connection arrangement (70) depending on the selected mounting position (I, II).

2. Arrangement (10) according to claim 1,
**characterized in that**
the processing arrangement (80) and/or the connection arrangement (70) is designed to adapt the actuation in order to perform the function assignment in such a way as to determine which of the functional elements (31, 32) is actuated in accordance with the detection function, and which of the functional elements (31, 32) is actuated in accordance with the further function.

3. Arrangement (10) according to claim 1 or 2,
**characterized in that**
the processing arrangement (80) is designed to actuate the first functional element (31) via at least one first connection element (71) of the connection arrangement (70) and the second functional element (32) via at least one second connection element (72) of the connection arrangement (70), the processing arrangement (80) and/or the connection arrangement (70) for adapting the control for the function assignment being designed such that the function assignment comprises a first assignment for the first mounting position (I) and a second assignment for the second mounting position (II), in order to provide the following in the first assignment:
- to control the detection function via the first connecting element (71) and the further function via the second connecting element (72), in particular to perform the detection function in the manner of a detection in a first environment (37) of the first functional element (31) and the further function in the manner of a screening of the first functional element (31) from a second environment (38) of the second functional element (32),
and for the second assignment
- to control the detection function via the second connection element (72) and the further function via the first connection element (71), in particular to perform the detection function in the manner of detection in the second environment (38) of the second functional element (32) and the further function in the manner of shielding the second functional element (32) from a first environment (37) of the first functional element (31),
so that the detection and shielding are preferably performed on different planes (21, 22) and different environments (37, 38) depending on the mounting position (I, II).

4. Arrangement (10) according to one of the preceding claims,
**characterized in that**
the connection arrangement (70) for adapting the control for the function assignment is designed in such a way that the connection arrangement (70) has at least one first connection element (71) which is electrically connected to the first functional element (31), and has at least one second connection element (72) which is electrically connected to the second functional element (32), the connection elements (71, 72) being suitable for electrical connection to different mating connection elements (91, 92) of the processing arrangement (80) in order to carry out the functional assignment by assigning the mating connection elements (91, 92) to the connection elements (71, 72).

5. Arrangement (10) according to one of the preceding claims,
**characterized in that**
the arrangement (10) has the processing arrangement (80), the processing arrangement (80) for adapting the actuation for the function assignment being designed in such a way that the processing arrangement (80) selectively actuates the first functional element (31) or the second functional element (32) in accordance with the detection function, and actuates the other of the functional elements (31, 32) in accordance with the further function.

6. Arrangement (10) according to one of the preceding claims,
**characterized in that**
the connection arrangement (70) has at least two connection elements (71, 72) which, in order to provide the connection interface (78) on both planes (21, 22), are each designed on both sides for connection to a mating connection element (91, 92) of the processing arrangement (80), preferably for detachably connecting the functional elements (31, 32) on different outer sides (35, 36) of the carrier element (20), the connection elements (71, 72) preferably having at least one through-plating (79) for this purpose.
and/or **in that** the connection arrangement (70) has the connection interface (78) on both sides of the carrier element (20) in order to connect at least one mating connection element (91, 92) selectively to the connection interface (78) on one of the two outer sides (35, 36) of the carrier element (20) in accordance with the different mounting positions (I, II), and in particular in order to carry out the functional assignment as a function of the selected outer side (35, 36) on which the connection is made.

7. Arrangement (10) according to one of the preceding claims,
**characterized in that**
the connection arrangement (70) has at least one first connection element (71), which is electrically connected to the first functional element (31) in order to variably provide the activation of the detection function or the further function at the first functional element (31), and has at least one second connection element (72), which is electrically connected to the second functional element (32), in order to variably provide the activation of the detection or further function at the second functional element (32), and has a third (73) and fourth (74) connection element, which are electrically connected to a first (41) and preferably a second (42) communication means on the carrier element (20) in order to provide activation of a communication function, preferably a near-field communication, preferably NFC.

8. Arrangement (10) according to one of the preceding claims,
**characterized in that**
the functional elements (31, 32) substantially and/or at least predominantly geometrically overlap in order to provide the further function as at least one-sided shielding of the detection function,
and/or that the functional elements (31, 32) are arranged in the same position and, in particular, congruently on the respective planes (21, 22), so that the detection function is provided in the same way but for different environments (37, 38) irrespective of the selection of the mounting position (I, II), in particular the same with regard to the position and extent of an electric field generated by the functional elements (31, 32).

9. Arrangement (10) according to one of the preceding claims,
**characterized in that**
the carrier element (20) is designed for mounting at the mounting positions (I, II) on opposite sides of the vehicle (1), and has a mounting adaptation (25) adapted to the mounting positions (I, II) in such a way that mounting at the mounting positions (I, II) can be carried out with the same orientation in the longitudinal direction (x) of the vehicle and, in particular, is prevented with a different orientation in the longitudinal direction (x) of the vehicle, preferably so that when mounted at the first mounting position (I), the first plane (21) faces away from an interior (7) of the vehicle (1) and the second plane (22) faces the interior (7), and when mounted at the second mounting position (II), the second plane (22) faces away from the interior (7) and the first plane (21) faces the interior (7), in particular in order to provide the detection and other functions symmetrically on the vehicle (1),
and/or **in that** the carrier element (20) is designed as an at least or exactly two-sided printed circuit board in order to provide a two-sided reception of the functional elements (31, 32), in which the first functional element (31) is fastened to a first outer side (35) of the carrier element (20) and the second functional element (32) is fastened to an opposite second outer side (36) of the carrier element (20) in order to provide the detection and further function on different outer sides (35, 36).

10. Arrangement (10) according to one of the preceding claims,
**characterized in that**
the functional elements (31, 32) are each designed both as a capacitive sensor electrode for providing the detection function and as a shielding electrode for providing the further function, in order to provide the functions depending on the function assignment and selected mounting position (I, II), wherein the functional elements (31, 32) are each geometrically identical with a flat shape for this purpose and preferably have spaced surface elements (33), in particular ribs, to reduce eddy current losses in the case of an adjacent communication interface (40) surrounding the functional elements (31, 32).

11. Arrangement (10) according to one of the preceding claims,
**characterized in that**
the processing arrangement (80) is designed to alternately control the functional elements (31, 32) for capacitive detection and a communication interface (40) surrounding the functional elements (31, 32) for near-field communication via the connection arrangement (70).

12. Arrangement (10) according to one of the preceding claims,
**characterized in that**
the carrier element (20) is designed as a printed circuit board with at least or exactly two planes (21, 22), in particular as a multilayer board, a connection arrangement (70) being arranged on both planes (21, 22), in particular by means of at least one through-hole plating (79).

13. Method for providing at least one function for an electronic system (2) of a vehicle (1) by means of an arrangement (10) according to one of the preceding claims, wherein
the first and the second electrically conductive functional element (31, 32) are provided at the different planes (21, 22) of the carrier element (20) in order to provide, variably assigned, a detection function for one of the planes (21, 22) and a further function for the other of the planes (21, 22),
**whereby the following steps are carried out:**
- carrying out a mounting of the carrier element (20) optionally at least at the first (I) or second (II) mounting position, wherein the mounting positions (I, II) are specific for different sides of the vehicle (1),
- connection of the processing arrangement (80) to the connection arrangement (70) on the carrier element (20) in order to electrically connect the functional elements (31, 32) to the processing arrangement (80), the connection arrangement (70) providing the connection interface (78) for controlling the functional elements (31, 32),
- adapt the control of the functional elements (31, 32) for the assignment of the functions depending on the selected mounting position (I, II).

14. A method according to any one of the preceding claims,
**characterized in that**
mounting is realized at the first mounting position (I) in a left-side door handle (3) of the vehicle (1) and at the second mounting position (II) in a right-side door handle (3) of the vehicle (1), in order to provide the detection function as a capacitive detection for detecting an activation action in the vehicle (1), and preferably to provide a communication interface (40) of the vehicle (1) for communication with an ID transmitter (6).

15. A method according to any one of the preceding claims,
**characterized in that**
the carrier element (20) with the functional elements (31, 32) and the connection arrangement (70) and, in particular, the processing arrangement (80) are designed in accordance with an arrangement (10) according to one of the preceding claims.

## Revendications

1. Agencement (10) pour fournir au moins une fonction à une électronique (2) d'un véhicule (1), de préférence à une électronique de poignée de porte (2) du véhicule (1), de préférence à un capteur capacitif (4) pour détecter une action d'activation sur le véhicule (1) et/ou à une interface de communication (40) du véhicule (1), présentant :
- un élément de support (20) adapté pour être monté à des positions de montage (I, II) sur différents côtés du véhicule (1) afin d'effectuer sélectivement le montage au moins à une première (I) ou une deuxième (II) des positions de montage (I, II),
- un premier élément fonctionnel électriquement conducteur (31) sur un premier plan (21) et un deuxième élément fonctionnel électriquement conducteur (32) sur un deuxième plan (22) de l'élément de support (20), les éléments fonctionnels (31, 32) étant disposés l'un au-dessus de l'autre et étant réalisés au moins partiellement de manière à coïncider, afin de mettre à disposition, de manière variable, une fonction de détection pour l'un des plans (21, 22) et une autre fonction, notamment une fonction de blindage, pour l'autre des plans (21, 22),
- un agencement de raccordement (70) pour connecter électriquement les éléments fonctionnels (31, 32) à un agencement de traitement (80) afin de fournir une interface de raccordement (78) pour commander les éléments fonctionnels (31, 32) pour l'attribution des fonctions en fonction de la position de montage sélectionnée (I, II),
**caractérisé en ce que**
l'agencement de raccordement (70) est réalisé pour l'adaptation de la commande pour l'attribution de fonction de telle sorte que l'interface de raccordement (78) est mise à disposition différemment sur les plans (21, 22) respectifs afin de procéder à une attribution différente d'éléments de raccordement opposés (91, 92) de l'agencement de traitement (80) à des éléments de raccordement (71, 72) de l'agencement de raccordement (70) en fonction de la position de montage sélectionnée (I, II).

2. Agencement (10) selon la revendication 1,
**caractérisé en ce que**
l'agencement de traitement (80) et/ou l'agencement de raccordement (70) est réalisé pour l'adaptation de la commande, afin d'effectuer l'attribution de fonction à la manière d'une détermination, lequel des éléments fonctionnels (31, 32) est commandé selon la fonction de détection, et lequel des éléments fonctionnels (31, 32) est commandé selon l'autre fonction.

3. Agencement (10) selon la revendication 1 ou 2,
**caractérisé en ce que**
l'agencement de traitement (80) est réalisé pour commander le premier élément fonctionnel (31) par au moins un premier élément de raccordement (71) de l'agencement de raccordement (70) et le deuxième élément fonctionnel (32) par au moins un deuxième élément de raccordement (72) de l'agencement de raccordement (70), l'agencement de traitement (80) et/ou l'agencement de raccordement (70) étant réalisé pour l'adaptation de la commande pour l'attribution de fonction de telle sorte que l'attribution de fonction comprenne une première attribution pour la première position de montage (I) et une deuxième attribution pour la deuxième position de montage (II), afin d'obtenir, lors de la première attribution
- commander la fonction de détection par l'intermédiaire du premier élément de raccordement (71) et l'autre fonction par l'intermédiaire du deuxième élément de raccordement (72), afin notamment d'exécuter la fonction de détection à la manière d'une détection dans un premier environnement (37) du premier élément fonctionnel (31) et l'autre fonction à la manière d'un blindage du premier élément fonctionnel (31) par rapport à un deuxième environnement (38) du deuxième élément fonctionnel (32),
et pour la deuxième attribution
- commander la fonction de détection par l'intermédiaire du deuxième élément de raccordement (72) et l'autre fonction par l'intermédiaire du premier élément de raccordement (71), afin notamment d'exécuter la fonction de détection dans le type de détection dans le deuxième environnement (38) du deuxième élément fonctionnel (32) et l'autre fonction dans le type de protection du deuxième élément fonctionnel (32) vis-à-vis d'un premier environnement (37) du premier élément fonctionnel (31),
de sorte que, de préférence, la détection et le blindage sont effectués sur différents desdits plans (21, 22) et différents desdits environnements (37, 38) en fonction de la position de montage (I, II).

4. Agencement (10) selon l'une quelconque des revendications précédentes,
**caractérisé en ce que**
l'agencement de raccordement (70) est réalisé pour l'adaptation de la commande pour l'attribution de fonctions de telle sorte que l'agencement de raccordement (70) présente au moins un premier élément de raccordement (71) qui est relié électriquement au premier élément fonctionnel (31) et au moins un deuxième élément de raccordement (72), qui est relié électriquement au deuxième élément fonctionnel (32), les éléments de agencement (71, 72) étant adaptés pour être reliés électriquement à différents éléments de agencement homologues (91, 92) de l'agencement de traitement (80), afin de procéder à l'attribution de fonctions par une association des éléments d'agencement homologues (91, 92) aux éléments de agencement (71, 72).

5. Agencement (10) selon l'une quelconque des revendications précédentes,
**caractérisé en ce que**
l'agencement (10) présente l'agencement de traitement (80), l'agencement de traitement (80) étant réalisé pour l'adaptation de la commande pour l'attribution de fonction de telle sorte que l'agencement de traitement (80) commande au choix le premier élément fonctionnel (31) ou le deuxième élément fonctionnel (32) selon la fonction de détection, et commande l'autre des éléments fonctionnels (31, 32) selon l'autre fonction.

6. Agencement (10) selon l'une quelconque des revendications précédentes,
**caractérisé en ce que**
l'agencement de raccordement (70) présente au moins deux éléments de raccordement (71, 72) qui, pour la mise à disposition de l'interface de raccordement (78) sur les deux plans (21, 22), sont conçus respectivement des deux côtés pour la liaison avec un élément de raccordement opposé (91, 92) de l'agencement de traitement (80), de préférence pour la liaison amovible des éléments fonctionnels (31, 32) sur différents côtés extérieurs (35, 36) de l'élément de support (20), les éléments de raccordement (71, 72) présentant de préférence à cet effet au moins un contact traversant (79).
et/ou **en ce que** l'agencement de raccordement (70) présente l'interface de raccordement (78) des deux côtés sur l'élément de support (20), afin de raccorder, en fonction des différentes positions de montage (I, II), au moins un élément de contre-raccordement (91, 92) au choix sur l'une des deux faces extérieures (35, 36) de l'élément de support (20) à l'interface de raccordement (78), et en particulier afin de procéder à l'attribution de fonction en fonction de la face extérieure (35, 36) choisie sur laquelle le raccordement est effectué.

7. Agencement (10) selon l'une quelconque des revendications précédentes,
**caractérisé en ce que**
l'agencement de raccordement (70) présente au moins un premier élément de raccordement (71) qui est relié électriquement au premier élément fonctionnel (31) pour fournir par ce biais de manière variable la commande de la fonction de détection ou de l'autre fonction au premier élément fonctionnel (31), et présente au moins un deuxième élément de raccordement (72) qui est relié électriquement au deuxième élément fonctionnel (32), pour fournir de manière variable la commande de la fonction de détection ou de l'autre fonction au niveau du deuxième élément fonctionnel (32), et présente un troisième (73) et un quatrième (74) élément de raccordement qui sont reliés électriquement à un premier (41) et de préférence à un deuxième (42) moyen de communication sur l'élément de support (20), pour fournir une commande d'une fonction de communication, de préférence une communication en champ proche, de préférence NFC, par l'intermédiaire de ceux-ci.

8. Agencement (10) selon l'une quelconque des revendications précédentes,
**caractérisé en ce que**
les éléments fonctionnels (31, 32) se recouvrent géométriquement pour l'essentiel et/ou au moins en majeure partie, afin de fournir l'autre fonction de blindage au moins unilatéral de la fonction de détection,
et/ou **en ce que** les éléments fonctionnels (31, 32) sont disposés dans la même position et en particulier de manière à coïncider sur les plans respectifs (21, 22), de sorte que la fonction de détection est mise à disposition indépendamment du choix de la position de montage (I, II) de la même manière mais pour des environnements différents (37, 38), en particulier de manière identique en ce qui concerne la position et l'extension d'un champ électrique généré par les éléments fonctionnels (31, 32).

9. Agencement (10) selon l'une quelconque des revendications précédentes,
**caractérisé en ce que**
l'élément de support (20) est réalisé pour le montage dans les positions de montage (I, II) sur des côtés opposés du véhicule (1), et présente une adaptation de montage (25) adaptée aux positions de montage (I, II) de telle sorte que le montage dans les positions de montage (I, II) peut être réalisé avec la même orientation dans la direction longitudinale (x) du véhicule et est en particulier empêché avec une orientation différente dans la direction longitudinale (x) du véhicule, de préférence de telle sorte que, lors du montage dans la première position de montage (I), le premier plan (21) soit détourné d'un espace intérieur (7) du véhicule (1) et le deuxième plan (22) soit tourné vers l'espace intérieur (7), et que, lors du montage dans la deuxième position de montage (II), le deuxième plan (22) soit détourné de l'espace intérieur (7) et le premier plan (21) soit tourné vers l'espace intérieur (7), afin de fournir en particulier la fonction de détection et les autres fonctions de manière symétrique sur le véhicule (1),
et/ou **en ce que** l'élément de support (20) est réalisé sous la forme d'une carte de circuit imprimé au moins ou exactement à deux faces, afin de fournir un logement bilatéral des éléments fonctionnels (31, 32), dans lequel le premier élément fonctionnel (31) est fixé sur une première face extérieure (35) de l'élément de support (20) et le deuxième élément fonctionnel (32) est fixé sur une deuxième face extérieure opposée (36) de l'élément de support (20), afin de fournir la fonction de détection et autre sur des faces extérieures différentes (35, 36).

10. Agencement (10) selon l'une quelconque des revendications précédentes,
**caractérisé en ce que**
les éléments fonctionnels (31, 32) sont respectivement réalisés aussi bien comme une électrode de capteur capacitive pour fournir la fonction de détection que comme une électrode de blindage pour fournir l'autre fonction, afin de fournir les fonctions en fonction de l'affectation des fonctions et de la position de montage sélectionnée (I, II), les éléments fonctionnels (31, 32) étant à cet effet respectivement réalisés de manière géométriquement identique avec une forme plane, et présentant de préférence des éléments de surface (33) espacés, en particulier des nervures, pour réduire les pertes par courants de Foucault dans une interface de communication (40) voisine et entourant les éléments fonctionnels (31, 32).

11. Agencement (10) selon l'une quelconque des revendications précédentes,
**caractérisé en ce que**
l'agencement de traitement (80) est réalisé pour commander alternativement, par l'intermédiaire de l'agencement de raccordement (70), les éléments fonctionnels (31, 32) pour la détection capacitive et une interface de communication (40) entourant les éléments fonctionnels (31, 32) pour la communication en champ proche.

12. Agencement (10) selon l'une quelconque des revendications précédentes,
**caractérisé en ce que**
l'élément de support (20) est réalisé sous la forme d'une carte de circuit imprimé avec les au moins ou exactement deux plans (21, 22), en particulier sous la forme d'une carte multicouche, un agencement de raccordement (70) étant disposé sur les deux plans (21, 22), en particulier au moyen d'au moins un contact traversant (79).

13. Procédé pour fournir au moins une fonction à une électronique (2) d'un véhicule (1) par un ensemble (10) selon l'une des revendications précédentes, dans lequel le premier et le deuxième éléments fonctionnels électriquement conducteurs (31, 32) sont prévus sur les différents plans (21, 22) de l'élément de support (20) afin de fournir une fonction de détection associée de manière variable à l'un des plans (21, 22) et une autre fonction à l'autre des plans (21, 22),
**les étapes suivantes étant effectuées:**
- effectuer un montage de l'élément de support (20) sélectivement au moins à la première (I) ou à la deuxième (II) position de montage, les positions de montage (I, II) étant spécifiques à différents côtés du véhicule (1),
- connecter l'agencement de traitement (80) à l'agencement de raccordement (70) sur l'élément de support (20) pour connecter électriquement les éléments fonctionnels (31, 32) à l'agencement de traitement (80), l'agencement de raccordement (70) fournissant l'interface de raccordement (78) pour commander les éléments fonctionnels (31, 32),
- adapter la commande des éléments fonctionnels (31, 32) pour l'attribution des fonctions en fonction de la position de montage sélectionnée (I, II).

14. Procédé selon l'une quelconque des revendications précédentes,
**caractérisé en ce que**
le montage s'effectue à la première position de montage (I) dans une poignée de porte (3) du côté gauche du véhicule (1) et à la deuxième position de montage (II) dans une poignée de porte (3) du côté droit du véhicule (1), afin de mettre à disposition la fonction de détection comme une détection capacitive pour la détection d'une action d'activation dans le véhicule (1), et de préférence de mettre à disposition une interface de communication (40) du véhicule (1) pour la communication avec un transmetteur ID (6).

15. Procédé selon l'une quelconque des revendications précédentes,
**caractérisé en ce que**
l'élément de support (20) avec les éléments fonctionnels (31, 32) et l'agencement de raccordement (70) et en particulier l'agencement de traitement (80) sont réalisés conformément à un agencement (10) selon l'une des revendications précédentes.
